Europäisches Patentamt

European Patent Office

Office européen des brevets

(19)

(11) Veröffentlichungsnummer : **0 170 727**
**B1**

## (12) EUROPÄISCHE PATENTSCHRIFT

(45) Veröffentlichungstag der Patentschrift :
26.04.89

(51) Int. Cl.⁴ : **G 06 F 11/20**

(21) Anmeldenummer : 84115749.8

(22) Anmeldetag : 18.12.84

(54) Integrierter Schreib-Lesespeicher.

(30) Priorität : 02.08.84 DE 3428552

(43) Veröffentlichungstag der Anmeldung :
12.02.86 Patentblatt 86/07

(45) Bekanntmachung des Hinweises auf die Patenterteilung : 26.04.89 Patentblatt 89/17

(84) Benannte Vertragsstaaten :
AT DE FR GB IT NL

(56) Entgegenhaltungen :
EP--A-- 0 094 645
WO--A--80 /017 32
JAPANESE JOURNAL OF APPLIED PHYSICS, Band
22, Suppl. 22-1, 1983, Seiten 63-67, Tokyo, JP; K.
SHIMOHIGASHI u.a.: "Redundancy techniques for
dynamic RAMs"
ELECTRONICS INTERNATIONAL, Band 54, no. 15, 28.
Juli 1981, Seiten 127-130, New York, US; R. ABBOTT
u.a.: "Equipping a line of memories with spare cells"

(73) Patentinhaber : Siemens Aktiengesellschaft Berlin
und München
Wittelsbacherplatz 2
D-8000 München 2 (DE)

(72) Erfinder : Wawersig, Jürgen. Ing.
Plievierpark 10
D-8000 München 83 (DE)
Erfinder : Kantz, Dieter, Dipl.-Ing.
Heiglhofstrasse 45
D-8000 München 70 (DE)

**Beschreibung**

Gegenstand der vorliegenden Erfindung ist ein integrierter Schreib-Lesespeicher nach dem Oberbegriff des Patentanspruches 1.

Schreib-Lesespeicher der o. g. Art sind allgemein bekannt und z. B. in « 1981 IEEE International Solid-State Circuits Conference », S. 80, 81, 84 und 85 beschrieben. Dort handelt es sich um dynamische Schreib-Lesespeicher, deren einzelne Speicherzellen als Ein-Transistor-Speicherzellen ausgebildet sind.

Entsprechende Schreib-Lesespeicher, insbesondere solche mit Aktivierung von Dekodern, sind auch aus « Japanese Journal of Applied Physics. Supplements, vol. 22 (1983) suppl. n° 22-1, Tokyo, Japan », Seiten 63 bis 67, « Redundancy Techniques for Dynamic RAMS » bekannt.

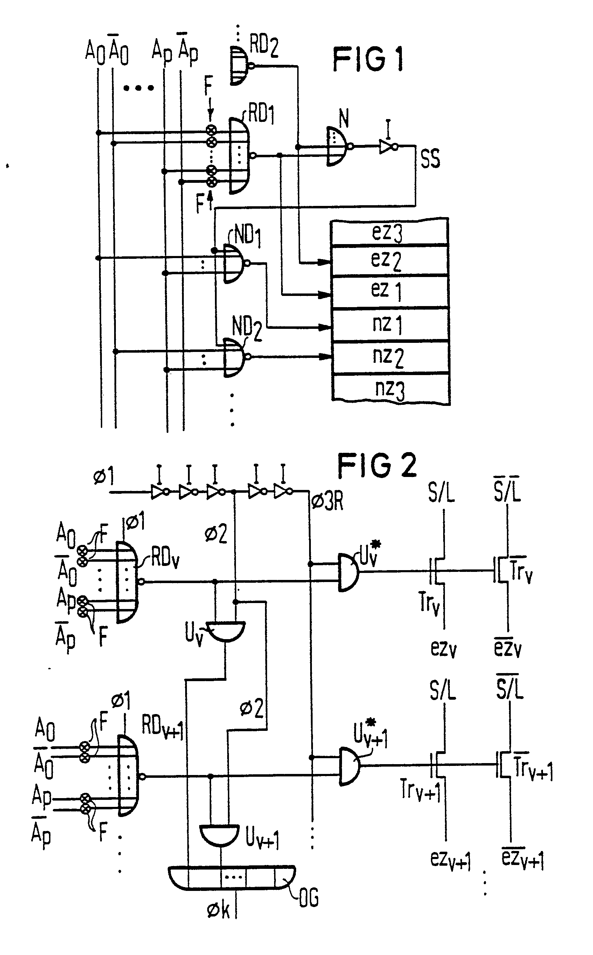

Bei mit Redundanz ausgestatteten Schreib-Lesespeichern ist die Möglichkeit gegeben, zu defekten Speicherzellen führende Spalten bzw. Zeilenleitungen der Speichermatrix elektrisch zu deaktivieren, d. h. funktionsunfähig zu machen und dafür eine identische redundante Matrixleitung zu aktivieren. Dies geschieht in der Regel durch Auftrennen von leitenden Verbindungen (fusible link), die den der redundanten Matrixleitung zugehörigen Adreßdekoder (Redundanzdekoder) im zunächst nicht aufgetrennten Zustand als nicht ausgewählt erscheinen läßt. Durch das Auftrennen wird infolge entsprechender Ausgestaltung des der redundanten Matrixleitung zugehörigen Redundanzdekoders in dem für den Normalbetrieb vorgesehenen Teil der Speichermatrix erreicht, daß aufgrund der Adressierung der ersetzten Spalte oder Zeile nur die nunmehr aktivierte entsprechende redundante Matrixleitung anspricht. Auf welche Art man dies in üblicher Weise erreicht, wird im folgenden anhand der Fig. 1 erläutert.

Es ist verständlich, daß der für die Deaktivierung der defekten Matrixleitung und der Aktivierung der Ersatzleitung erforderliche Aufwand an Schaltungsmaßnahmen und damit an Chipfläche möglichst gering sein soll. Außerdem ist es erwünscht, daß diese Maßnahmen mit einer möglichst geringen Zeitverzögerung beim Betrieb des Speichers verbunden sind. Schließlich soll der Betrieb des Speichers keine Einbuße an Verläßlichkeit erleiden.

Es ist deshalb Aufgabe der vorliegenden Erfindung, den bekannten Schreib-Lesespeicher derart weiterzubilden, daß diesen Forderungen Rechnung getragen wird, ohne daß dies mit störenden Nachteilen verbunden ist.

Diese Aufgabe wird bei einem integrierten Schreib-Lesespeicher der eingangs genannten Art durch die Merkmale des kennzeichnenden Teiles des Patentanspruches 1 gelöst.

Vorteilhafte Weiterbildungen der Erfindung sind in jeweiligen Unteransprüchen gekennzeichnet.

Im folgenden wird nun die Erfindung anhand der Figuren 1 bis 5 näher erläutert.

Es zeigen :

Fig. 1 das Redundanzprinzip nach dem Stande der Technik,

Fig. 2 die erfindungsgemäße Verschaltung von Redundanzdekodern mit den zugehörigen Schreib-Leseleitungen der redundanten Zeilen und die Erzeugung zugehöriger Taktsignale, unter Verwendung von Logiksymbolen,

Fig. 2a die erfindungsgemäße Verknüpfung eines Schaltungsteiles zur Auswahl einer redundanten Zeile mit einem Schaltungsteil zur Auswahl einer für den Normalbetrieb vorgesehenen Zeile, jeweils mit Logiksymbolen dargestellt,

Fig. 3 die Realisierung der Schaltung nach Fig. 2 mittels MOS-Transistoren,

Fig. 3a die erfindungsgemäße Erzeugung eines Aktivierungssignales Ø3R,

Fig. 3b die erfindungsgemäße Erzeugung eines Aktivierungssignales Ø3 und dessen vorteilhafte Verschaltung mit einem Normaldekoder,

Fig. 3c ein Zeitdiagramm für die verwendeten Taktsignale,

Fig. 4a eine schematische Darstellung eines bekannten Schreib-Lesespeichers mit Mittendekoder,

Fig. 4b eine schematische Darstellung eines erfindungsgemäßen Schreib-Lesespeichers mit Mittendekoder und redundantem Speicherbereich,

Fig. 5 einen Schaltplan zur erfindungsgemäßen Ausgestaltung von Mittendekodern und Schaltern.

Bezüglich der Bezugszeichen wurde folgende Konvention getroffen :

der verwendete Index « $\mu$ » hat einen Wertebereich von 1 bis m (m = Gesamtzahl der für den Normalbetrieb vorgesehenen Zeilen),

der Index « v » einen Wertebereich von 1 bis n (n = Gesamtzahl der für den Redundanzfall vorgesehenen Ersatzzeilen) ; « 1 » wird bei Bezeichnungen verwendet, die eine linke Zellenfeldhälfte betreffen,

« r » entsprechend für eine rechte Zellenfeldhälfte,

« p » steht für die Gesamtzahl von Adreßleitungen (ohne komplementäre Adreßleitungen).

In Fig. 1 ist das übliche Adressierprinzip eines bekannten Schreib-Lesespeichers z. B. anhand der Zeilenleitungen gezeigt. Die Normaldekoder $ND_1$, $ND_2$, ....... dienen der Adressierung der dem Normalbetrieb zugeordneten Normalzeilen $nz_1$, $nz_2$, ....., während die Dekoder $RD_1$, $RD_2$ neben möglichen weiteren Dekodern als Redundanzdekoder für die Beaufschlagung von in der Matrix vorgesehenen redundanten Zeilen $ez_1$, $ez_2$ usw. vorgesehen sind. Es ist aus Fig. 1 ersichtlich, daß jeder Normaldekoder $ND_1$, $ND_2$ usw. an jedem Eingang von jeweils einer der paarweise zueinander inversen Adreßleitungen beaufschlagt wird, so daß immer eine der Adreßleitungen $A_0$ oder $\bar{A}_0$, $A_1$ oder $\bar{A}_1$ usw. angeschlossen ist. Im Gegensatz hierzu sind die jeweils einer redundanten

Zeile $ez_1$, $ez_2$ usw. (bzw. Spalte) zugeordneten und durch je ein NOR-Gatter gegebenen Redundanzdekoder $RD_1$, $RD_2$, usw. derart durch die an sich für den Normalbetrieb vorgesehenen Adreßleitungen $A_o$, $\bar{A}_o$ bis $A_p$, $\bar{A}_p$ gesteuert, daß der einzelne Redundanzdekoder sowohl durch alle Adressleitungen als auch durch alle hierzu invertierten Adreßleitungen (also $A_o$, $\bar{A}_o$, $A_1$, $\bar{A}_1$, usw.) beaufschlagt ist. Wenn man nun auftrennbare Verbindungen F (fuses) zwischen einem der vorgesehenen Redundanzdekoder $RD_1$, $RD_2$ usw. und den zugehörigen Adreßleitungen $A_o$ oder $\bar{A}_o$, $A_1$ oder $\bar{A}_1$ usw. auftrennt und die übrigen Verbindungen von den Adreßleitungen zu dem betreffenden Redundanzdekoder beibehält, so stimmt ersichtlich die Anschaltung dieses Redundanzdekoders an die Gesamtheit der vorgesehenen Zeilenadreßleitungen $A_o$ bis $\bar{A}_p$ mit der Anschaltung genau eines einzigen der für den Normalbetrieb vorgesehenen Normaldekoder $ND_1$, $ND_2$ usw. überein, so daß beide Dekoder auf dieselbe Adreßkombination ansprechen.

Es soll aber dann aufgrund der genannten bleibenden Änderung nur der durch diese Änderung aktivierte Redundanzdekoder ansprechen. Aus diesem Grund sind die Ausgänge aller vorgesehenen und einander gleichen Redundanzdekoder-NOR-Gatter $RD_1$, $RD_2$ usw. jeweils an je einen Eingang eines gemeinsamen weiteren NOR-Gatters N angeschlossen, dessen Ausgang über einen Inverter I an je einen weiteren Eingang aller der für den Normalbetrieb vorgesehenen Adreßdekoder $ND_1$, $ND_2$ usw. angeschlossen ist. Ist nun einer der Redundanzdekoder $RD_1$, $RD_2$...... aktiviert und damit durch die an den Adreßleitungen $A_o$, $\bar{A}_o$, ........., $A_p$, $\bar{A}_p$ liegenden Adreßimpulse derart beaufschlagt, daß an jedem Eingang des den Redundanzdekoder bildenden NOR-Gatters $RD_1$ bzw. $RD_2$ usw. eine logische « 0 » anliegt, dann wird die zugehörige redundante Zeile aktiviert und zwar aufgrund der dann am Ausgang des Inverters I liegenden logischen « 1 ». Diese « 1 » führt aber dazu, daß an keinem Ausgang der für den Normalbetrieb vorgesehenen Normaldekoder $ND_1$, $ND_2$ usw. eine « 1 » möglich ist, denn eine eingangsseitige « 1 » an irgendeinem der Eingänge jedes der vorgesehenen, aus NOR-Gattern gebildeten Normaldekoder $ND_1$, $ND_2$ etc verhindert, daß am Ausgang dieser Dekoder eine « 1 » entsteht und somit eine Aktivierung der zugehörigen Zeilenleitungen stattfindet.

Die Adressierung der Matrix hinsichtlich der Spaltenleitungen geschieht unter Verwendung anderer Adreßleitungen und Dekoder auf analoge Art.

Wird bei einer Ausgestaltung der Adressierung entsprechend. Fig. 1 ein vorher (aufgrund der bleibenden Änderung) programmierter Redundanzdekoder $RD_1$, $RD_2$...... durch eine entsprechende Adreßkombination angesprochen, so wird durch diesen ausgewählten Redundanzdekoder $RD_1$, $RD_2$.... ein Sperrsignal SS = High (=logisch « 1 ») erzeugt. Dieses Signal wird zusätzlich zu den Adressen an einen eigens hierfür vorgesehenen Eingang eines jeden Normaldekoders $ND_1$,

$ND_2$ usw. gelegt, sodaß der durch die angelegte Adreßkombination ausgewählte Normaldekoder gesperrt wird. Andererseits aktiviert der angesprochene Redundanzdekoder die ihm jeweils zugeordnete und dem Ersatz dienende Matrixzeile bzw. Matrixspalte.

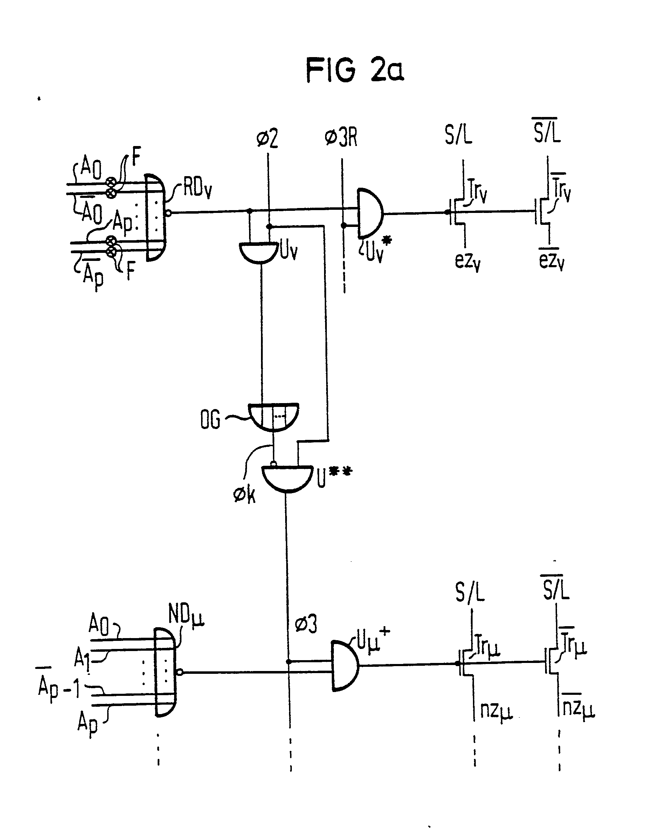

Bei einem erfindungsgemäßen Schreib-Lesespeicher enthält nach Fig. 2 jeder der Zeilenredundanzdekoder $RD_v$ (bzw. Spaltenredundanzdekoder) ein NOR-Gatter, dessen Eingängen jeweils eine der insgesamt vorgesehenen, zueinander paarweise inversen Zeilenadressleitungen $A_o$, $\bar{A}_o$,...... $A_p$, $\bar{A}_p$ (bzw. Spaltenadreßleitungen) zugeordnet sind, wobei die Verbindung F zwischen dem einzelnen Eingang und der ihn jeweils steuernden Adreßleitung auftrennbar ausgestaltet ist. In Fig. 2 sind der einer ersten redundanten Zeile $ez_v$ bzw. $\bar{ez}_v$ und der einer weiteren redundanten Zeile $ez_{v+1}$ bzw. $\bar{ez}_{v+1}$ zugeordnete Redundanzdekoder dargestellt und mit $RD_v$ bzw. $RD_{v+1}$ bezeichnet. Die Darstellung beschränkt sich aus Übersichtlichkeitsgründen nur auf zwei Redundanzdekoder, in der Beschreibung sind nur die Bezugszeichen eines dieser Dekoder angegeben. Jedem der Redundanzdekoder $RD_v$ sind jeweils zwei UND-Gatter, $U_v$ und $U_v^*$ zugeordnet, die jeweils zwei Signaleingänge aufweisen. Der eine dieser zwei Signaleingänge beider UND-Gatter $U_v$, $U_v^*$ liegt am Ausgang des den zugehörigen Redundanzdekoder $RD_v$ darstellenden NOR-Gatters. Der Ausgang jedes einzelnen UND-Gatters $U_v$ ist bei jedem der vorgesehenen Zeilenredundanzdekoder $RD_v$ (bzw. Spaltenredundanzdekoder) an je einen Eingang eines für alle Redundanzdekoder gemeinsamen ODER-Gatters OG gelegt, während der andere Signaleingang aller UND-Gatter $U_v$ von einem gemeinsamen Taktsignal Ø2 gesteuert ist. Der andere Eingang jedes UND-Gatters $U_v^*$ wird von einem gemeinsamen Aktivierungssignal Ø3R gesteuert. Der Ausgang jedes UND-Gatters $U_v^*$ gibt frei bzw. schließt eine durch je einen Transfertransistor $Tr_v$ bzw. $\bar{Tr}_v$ gegebene Verbindung zwischen dem betreffenden Zeilenredundanzdekoder $RD_v$ (bzw. Spaltenredundanzdekoder) jeweils zugeordneten redundanten Zeilenleitungen $ez_v$, $\bar{ez}_v$ (bzw. Spaltenleitungen) und einem der Zeile bzw. Spalte gemeinsamen Dateneingang bzw. Datenausgang S/L bzw. $\bar{S}/\bar{L}$.

Die Erzeugung des Taktsignales Ø2 bzw. des Aktivierungssignales Ø3R (R = Redundanz) geschieht z. B. in der aus Fig. 2 ersichtlichen Weise, indem ein für den Betrieb aller Redundanzdekoder $RD_v$ der Speicherschaltung gemeinsam vorgegebenes Taktsignal Ø1 über eine Kette aus drei einander gleichen und hintereinandergeschalteten Invertern I zur Erzeugung des zur Mitsteuerung der UND-Gatter $U_v$ vorgesehenen Taktsignales Ø2 dient. Zwecks Erzeugung des zur Mitsteuerung der UND-Gatter $U_v^*$ benötigten Aktivierungssignales Ø3R wird das auf die soeben beschriebene Weise erhaltene Taktsignal Ø2 über die Serienschaltung zweier weiterer Inverter I verzögert.

In Fig. 2a ist nun das Zusammenspiel zwischen den einzelnen Redundanzdekodern $RD_v$ und den

Normaldekodern $ND_\mu$ gezeigt. Es sind ein beliebiger Redundanzdekoder $RD_v$ und ein beliebiger Normaldekoder $ND_\mu$ dargestellt. Das aus Fig. 2 ersichtliche und eingangsseitig über die UND-Gatter $U_v$ von der Gesamtheit der Redundanzdekoder $RD_v$ beaufschlagte ODER-Gatter OG liegt mit seinem Ausgangssignal Øk, genannt Inhibitsignal Øk, über einen Inverter am einen Eingang eines UND-Gatters U**, an dessen anderem Eingang das Taktsignal Ø2 liegt. Der Ausgang dieses UND-Gatters U**, das ebenso wie das ODER-Gatter OG allen Zeilenredundanzdekodern $RD_v$ gemeinsam zugeordnet ist, steuert den einen Eingang von m UND-Gattern $U_\mu^+$ mit jeweils zwei Eingängen, von denen der eine jeweils an dem Ausgang des UND-Gatters U** und der andere an dem Ausgang des dem UND-Gatter $U_\mu^-$ jeweils zugeordneten Normaladreßdekoders $ND_\mu$ liegt. Jedem der m für den Normalbetrieb vorgesehenen Normaldekoder $ND_\mu$ ist somit jeweils eines dieser UND-Gatter $U_\mu^-$ zugeordnet, das, wie aus Fig. 2a hervorgeht, dem UND-Gatter $U_v^*$ der einzelnen Redundanzdekoder $RD_v$ entspricht. Es wird dementsprechend an seinem anderen Eingang durch ein dem Aktivierungssignal O3R entsprechendes Aktivierungssignal Ø3 gesteuert. Dieses Aktivierungssignal Ø3 wird vom Ausgang des UND-Gatters U** geliefert. Jedes UND-Gatter $U_\mu^-$ spricht aber nur dann an, wenn am Ausgang des den Normaldekoder $ND_\mu$ darstellenden NOR-Gatters eine « 1 » anhängig ist, d. h. wenn an keinem der Adreßeingänge des Normaldekoders $ND_\mu$ eine « 1 » liegt. Der Ausgang des UND-Gatters $U_\mu^-$ steuert zu den zugehörigen Zeilen $nz_\mu$ und $ñz_\mu$, die für den Normalbetrieb vorgesehen sind, gehörende Transfertransistoren $Tr_\mu$ bzw. $\bar{Tr}_\mu$, die eine Freigabe einer Verbindung zwischen diesen Zeilen $nz_\mu$, $ñz_\mu$ und einem Dateneingang bzw. Datenausgang S/L, $\bar{S}/\bar{L}$ innerhalb der Speichermatrix bilden.

Hinsichtlich der Wirkung der in Fig. 2 bzw. 2a dargestellten Schaltung gemäß der Erfindung läßt sich nun folgendes feststellen : Da die in Fig. 2a gezeigte Schaltung für den Normaldekoder $ND_\mu$ in getakteten Schreib-Lesespeichern allgemein angewendet wird und demgemäß das UND-Gatter $U_\mu^-$ zum Zwecke der Verbindung der ausgewählten Zeilen $nz_\mu$ und $ñz_\mu$ mit den Datenein- bzw. ausgängen S/L bzw. $\bar{S}/\bar{L}$ sowie ein Aktivierungssignal Ø3 in der Regel vorgesehen sind, spart man die in Fig. 1 vom Inverter I an je einen Eingang der Normaldekoder $ND_\mu$ zu legende und das Signal SS führende Leitung und den durch diese Leitung zu beaufschlagenden Eingang der vorhandenen Normaldekoder $ND_\mu$ ein, was die Einsparung eines Eingangstransistors pro Normaldekoder $ND_\mu$ gegenüber der üblichen Ausgestaltung und damit ein rascheres Ansprechen bedeutet. Die Einsparung eines Eingangstransistors pro Normaldekoder $ND_\mu$ bedingt des weiteren sowohl eine Flächenersparnis als auch eine Laufzeitverkürzung.

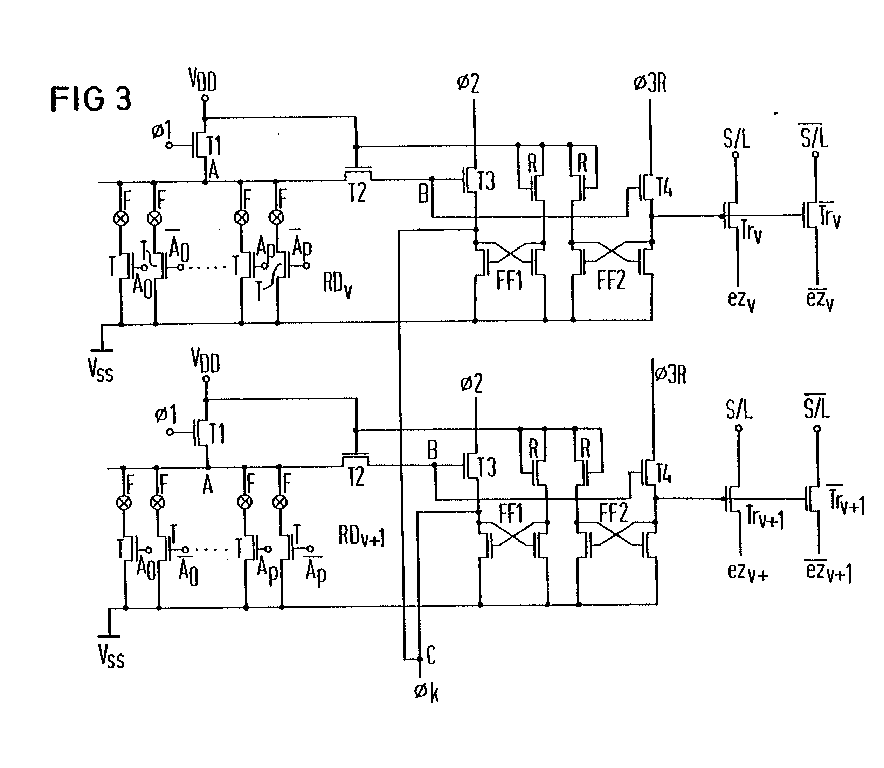

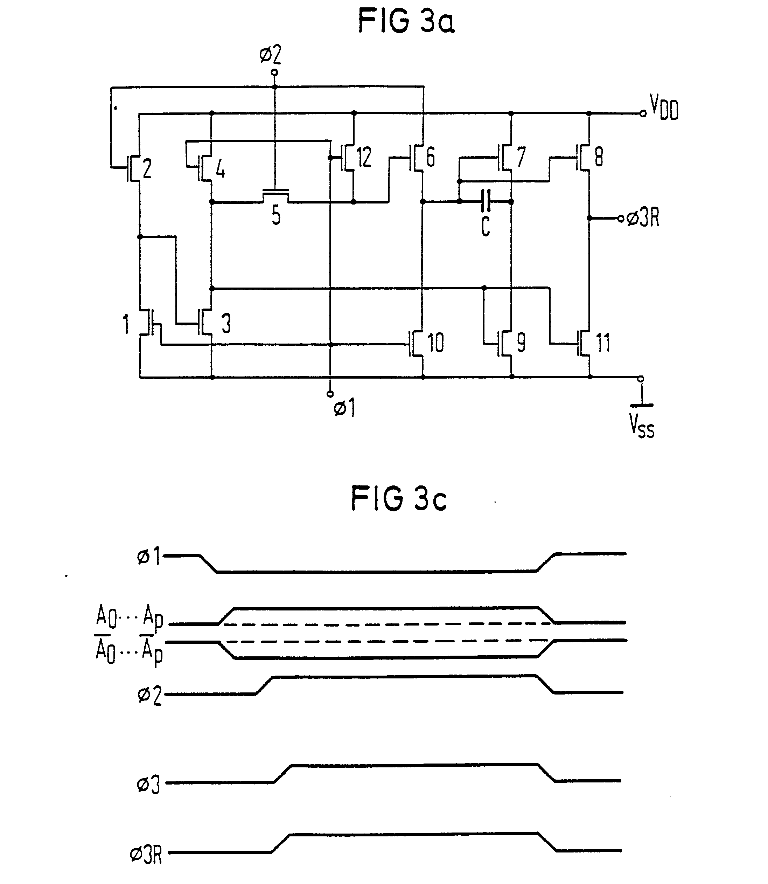

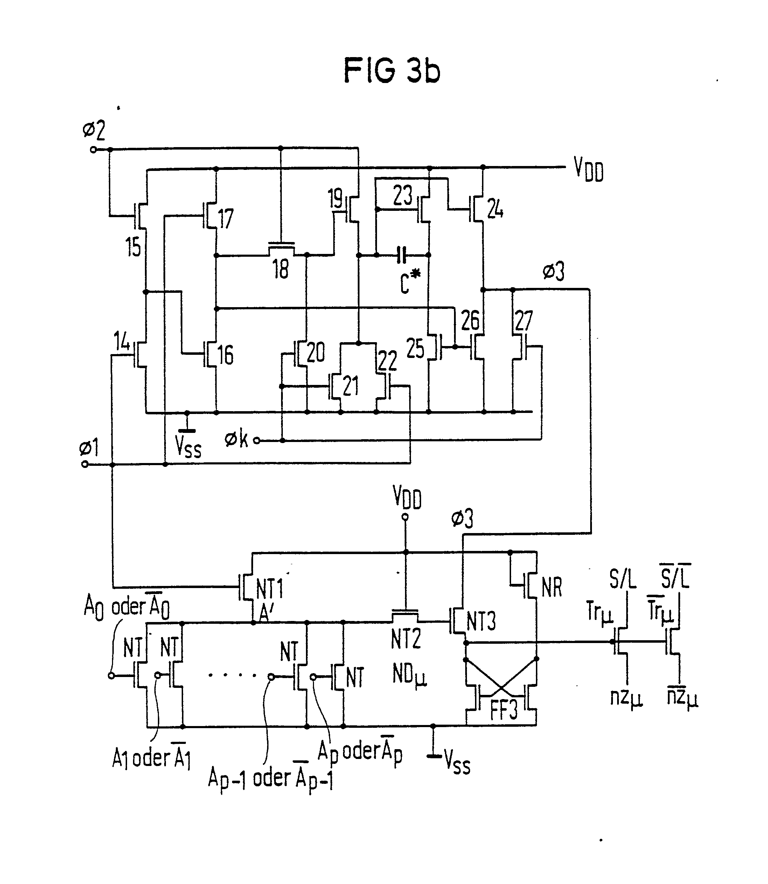

Die in Fig. 3 dargestellte Ausgestaltung für die einzelnen Redundanzdekoder $RD_v$ in MOS-Technik ist in der Wirkung der eines Redundanzdekoders $RD_v$ entsprechend Fig. 2 im wesentlichen gleich. Sie ist jedoch dem Betrieb eines dynamischen Speichers noch besser angepaßt. Bevorzugt erfolgt die Ausgestaltung — ebenso wie die Ausgestaltung der in Fig. 3a und 3b gezeigten ergänzenden Schaltungsteile — in n-Kanal-MOS-Technik, insbesondere wenn auch die übrigen Teile des Speichers in dieser Technik hergestellt sind. Hinsichtlich der Ausgestaltung der die einzelnen Redundanzdekoder bildenden Schaltungsteile ist dann Übereinstimmung gegeben.

Wie bei den in Fig. 3 dargestellten Redundanzdekodern $RD_v$ und $RD_{v-1}$ ersichtlich, ist jeder Zeilenadreßleitung $A_0$, $\bar{A}_0$, ...... $A_p$, $\bar{A}_p$ je ein Transistor T zugeordnet, dessen Gate je einen Signaleingang des im betreffenden Redundanzdekoder $RD_v$ enthaltenen NOR-Gatters bildet. Die Sourceanschlüsse dieser Transistoren T liegen gemeinsam an einem Bezugspotential $V_{ss}$, während ihre Drainanschlüsse gemeinsam den Ausgang A des NOR-Gatters bilden und außerdem über die Source-Drainstrecke eines von einem Taktsignal Ø1 gesteuerten Lasttransistors T1 mit einem ein Versorgungspotential $V_{DD}$ liefernden Versorgungsanschluß verbunden sind. Der Ausgang A des im jeweiligen Redundanzdekoder $RD_v$ enthaltenen NOR-Gatters liegt vermittels der Source-Drainstrecke eines weiteren Transistors T2 an einem Knoten B, der den eigentlichen Ausgang des betreffenden Redundanzdekoders $RD_v$ bildet und der dementsprechend zur Steuerung der Transfertransistoren $Tr_v$ bzw. $\bar{Tr}_v$ in noch zu beschreibender Weise dient, wobei durch diese Steuerung die dem betreffenden Redundanzdekoder $RD_v$ zugeordneten, redundanten Zeilenleitungen $ez_v$ und $ēz_v$ an den Dateneingang bzw. -ausgang S/L und $\bar{S}/\bar{L}$ geschaltet werden.

Zur Erzeugung des aus Fig. 2 bzw. 2a ersichtlichen Inhibitsignales Øk, das dort von dem ODER-Gatter OG geliefert wird, hat man im Falle der Redundanzdekoder $RD_v$ gemäß Fig. 3 bei jedem der vorgesehenen Redundanzdekoder $RD_v$ je einen weiteren MOS-Feldeffekttransistor T3, dessen Drainanschluß vom Taktsignal Ø2 beaufschlagt ist, dessen Gate an den Ausgang B des zugehörigen Redundanzdekoders $RD_v$ gelegt ist, und dessen Sourceanschluß über den einen Zweig eines ersten RS-Flip-Flops FF1 mit dem Bezugspotential $V_{SS}$ verbunden ist. Das vom Taktsignal Ø2 gesteuerte UND-Gatter $U_v$ in Fig. 2 bzw. 2a entspricht in Fig. 3 der elektrischen Verbindung des Sourceanschlusses des jeweiligen Transistors T3 mit dem Drain eines ersten und dem Gate eines zweiten Transistors, die das genannte RS-Flip-Flop FF1 bilden. Die beiden das RS-Flip-Flop FF1 bildenden Transistoren sind in bekannter Weise kreuzgekoppelt und liegen mit ihrem Sourceanschluß gemeinsam am Bezugspotential $V_{SS}$. Aufgrund der genannten Anschaltung des Transistors T3 an den einen Knoten des RS-Flip-Flops FF1, dessen zweiter Knoten über einen als Widerstand geschalteten Lasttransistor R mit der Klemme für das Versorgungspotential $V_{DD}$ verbunden ist, ist dieser in der Lage, das von dem

betreffenden Redundanzdekoder $RD_v$ für die Beeinflussung eines von ihm zu ersetzenden Normaldekoders $ND_\mu$ notwendige Inhitbitsignal $Øk$ zur Verfügung zu stellen. Dieses Inhibitsignal $Øk$ wird jeweils durch den von der Source des Transistors T3 und dem aus den mit ihr verbundenen Stellen des RS-Flip-Flops FF1 gebildeten Knoten geliefert und auf einen für alle diese RS-Flip-Flops FF1 und damit für alle Redundanzdekoder $RD_v$ gemeinsamen weiteren Knoten C gelegt, der in seiner Funktion dem ODER-Gatter OG in den Fig. 2 und 2a entspricht.

Ein weiteres RS-Flip-Flop FF2 liegt mit den Sourceanschlüssen seiner beiden kreuzgekoppelten Transistoren ebenfalls am Bezugspotential $V_{SS}$ und mit seinem einen Knoten über einen weiteren als Widerstand geschalteten Transistor R am Versorgungspotential $V_{DD}$. Der andere Knoten dieses RS-Flip-Flops FF2 liegt am Sourceanschluß eines dem Transistor T3 entsprechenden Transistors T4. Dieser wird an seinem Drain durch den Takt $Ø3R$ und an seinem Gate durch den Knoten B des zugehörigen Transistors T2 und damit durch den Ausgang des zugehörigen Redundanzdekoders $RD_v$ gesteuert. Der am Sourceanschluß des Transistors T4 gebildete Knoten ist seinerseits an die Gates der zugehörigen Transfertransistoren $Tr_v$ und $\overline{Tr}_v$ gelegt, wodurch die oben erwähnte Steuerung dieser beiden Transfertransistoren zustande kommt.

Man kann also, wie aus Fig. 3 ersichtlich, bei der dort gezeigten Ausgestaltung der Redundanzdekoder $RD_v$ auf eine explizite Realisierung des ODER-Gatters OG in Fig. 2 verzichten, da der Knoten C, der von den das Inhibitsignal $Øk$ liefernden Kombinationen Transistor T3 und RS-Flip-Flop FF1 der Redundanzdekoder $RD_v$ gemeinsam beaufschlagt wird, ersichtlich im Verhalten dem Ausgang des ODER-Gatters OG entspricht. Zu erwähnen ist noch, daß die verwendeten Transistoren in der Schaltung gemäß Fig. 3, ebenso auch in Fig. 3a und 3b sämtlich selbstsperrend und vom gleichen Kanaltyp, insbesondere vom n-Kanaltyp, sind.

In Fig. 3a ist eine MOS-Schaltung gezeigt, die zur Erzeugung des für die Beaufschlagung des Drainanschlusses des Transistors T4 in Fig. 3 in den vorgesehenen Redundanzdekodern $RD_v$ benötigten Aktivierungssignales $Ø3R$ dient und die an die Ausgestaltung der Redundanzdekoder gemäß Fig. 3 angepaßt ist. Das zu ihrer Beaufschlagung benötigte Taktsignal $Ø1$ ist auch für den normalen Betrieb des Speichers vorgesehen. Es kann aber auch ein Signal verwendet werden, das eigens zu diesem Zweck mittels eines Taktgenerators erzeugt wird. Verlangt wird von dem Taktsignal $Ø1$, daß es auf log. « 0 » geht, bevor Adressen über die Adressleitungen $A_0$....$\bar{A}_p$ an die Normaldekoder $ND_\mu$ und an die Redundanzdekoder $RD_v$ gelangen und bevor das Taktsignal $Ø2$ auf log. « 1 » schaltet.

Das Zeitverhalten des Taktsignales $Ø1$ im Hinblick auf die Signale an den Adreßleitungen $A_0$ bis $A_p$ bzw. $\bar{A}_0$ bis $\bar{A}_p$ ist aus dem Zeitdiagramm gemäß Fig. 3c zu ersehen. Die ansteigende Flanke der Signale an den Adreßleitungen $A_0$, $\bar{A}_0$, ....., $A_p$, $\bar{A}_p$ ist zeitlich gegenüber der fallenden Flanke des Taktsignales $Ø1$ verzögert, während die steigende Flanke des Taktsignales $Ø2$ zeitlich vor der ansteigenden Flanke der Aktivierungssignale $Ø3$ und $Ø3R$ liegt, deren ansteigende Flanken gleichzeitig kommen können.

Bei der in Fig. 3a dargestellten Schaltung zur Erzeugung des Aktivierungssignales $Ø3R$ bilden zwei Transistoren 1 und 2 zusammen einen ersten Inverter, bei dem der vom Taktsignal $Ø1$ gesteuerte Schalttransistor 1 mit seinem Sourceanschluß am Bezugspotential $V_{ss}$ und mit seinem Drain einerseits über den vom Taktsignal $Ø2$ gesteuerten Lasttransistor 2 mit dem Versorgungspotential $V_{DD}$ verbunden ist und andererseits mit seiner Source zusammen mit dem Drain des Transistors 1 den Signalausgang des ersten Inverters bildet.

Dieser Signalausgang steuert den Schalttransistor 3 eines zweiten Inverters, dessen Lasttransistor 4 vom Taktsignal $Ø1$ gesteuert ist. Hinsichtlich der Anschaltung an das Bezugspotential $V_{ss}$ und das Versorgungspotential $V_{DD}$ entspricht der zweite Inverter 3, 4 völlig dem ersten Inverter 1, 2. Der durch einen Schaltungspunkt zwischen den beiden Transistoren 3 und 4 des zweiten Inverters gebildete Ausgang dieses Inverters ist a) über einen vom Taktsignal $Ø2$ gesteuerten Transfertransistor 5 an die Source eines vom Taktsignal $Ø1$ gesteuerten Transistors 12 geschaltet, dessen Drain mit dem Versorgungspotential $V_{DD}$ verbunden ist, und außerdem b) vermittels des soeben genannten Transfertransistors 5 an das Gate eines weiteren MOS-Feldeffekttransistors 6 gelegt, dessen Drain vom Taktsignal $Ø2$ beaufschlagt ist.

Der zuletzt genannte Transistor 6 ist mit seinem Sourceanschluß einerseits über die Source-Drainstrecke eines vom Taktsignal $Ø1$ gesteuerten Transistors 10 an das Bezugspotential $V_{ss}$ gelegt und außerdem mit den Gates zweier weiterer Transistoren 7 und 8 verbunden, deren Drainanschlüsse am Versorgungspotential $V_{DD}$ liegen. Bei dem Transistor 7 ist dabei zu bemerken, daß dessen Gate über einen Kondensator C mit dem eigenen Sourceanschluß verbunden ist. Außerdem ist der Sourceanschluß dieses Transistors 7 über die Drain-Sourcestrecke eines weiteren Transistors 9 mit dem Bezugspotential $V_{ss}$ verbunden. Weiterhin ist dabei der Transistor 9 an seinem Gate vom Ausgang des in bereits beschriebener Weise von den beiden Transistoren 3 und 4 gebildeten zweiten Inverters gesteuert. Das letztere gilt auch für einen weiteren Transistor 11, dessen Source am Bezugspotential $V_{ss}$ liegt und dessen Drain über den bereits beschriebenen Transistor 8 mit dem Versorgungspotential $V_{DD}$ verbunden ist. Der zu erzeugende Takt $Ø3R$ ist an einem Schaltungspunkt zwischen den beiden zuletzt genannten Transistoren 8 und 11 abnehmbar.

Die Schaltung für die Erzeugung des für die Normaldekoder $ND_\mu$ benötigten Aktivierungssignales $Ø3$ ist in Kombination mit der Schaltung eines beliebigen Normaldekoders $ND_\mu$ in Fig. 3b gezeigt, die nun beschrieben werden soll.

Ein aus den beiden Transistoren 14 und 15 bestehender, mit seinem Schalttransistor 14 am Bezugspotential $V_{ss}$ und mit seinem Lasttransistor 15 am Versorgungspotential $V_{DD}$ liegender erster Inverter ist bezüglich seines Schalttransistors 14 vom Taktsignal Ø1 und bezüglich seines Lasttransistors 15 durch das Taktsignal Ø2 gesteuert. Der durch einen Schaltungspunkt zwischen diesen beiden Transistoren 14 und 15 gegebene Ausgang des ersten Inverters steuert das Gate des Schalttransistors 16 eines weiteren Inverters. Dabei liegt der Schalttransistor 16 mit seinem Sourceanschluß ebenfalls am Bezugspotential $V_{ss}$ und mit seinem Drain am Sourceanschluß des die Verbindung zum Versorgungspotential $V_{DD}$ bildenden und vom Taktsignal Ø1 gesteuerten Lasttransistors 17 des zweiten Inverters. Ähnlich wie bei Fig. 3a ist der durch einen Schaltungspunkt zwischen dem Transistor 16 und 17 gegebene Inverterausgang an einen Transfertransistor 18 gelegt, dessen Gate vom Taktsignal Ø2 gesteuert ist. Der dem zweiten Inverter 16, 17 abgewandte stromführende Anschluß des Transfertransistors 18 liegt einerseits über einen — von dem von einer Schaltung gemäß Fig. 3 von den Redundanzdekodern $RD_v$ gelieferten Inhibitsignal Øk gesteuerten — Transistor 20 am Bezugspotential $V_{ss}$. Andererseits liegt er am Gate eines Transistors 19, dessen Drain durch das Taktsignal Ø2 beaufschlagt ist.

Mit seiner Source ist der zuletzt genannte Transistor 19 über die Parallelschaltung zweier weiterer Transistoren 21 und 22 mit dem Bezugspotential $V_{ss}$ verbunden, wobei das Gate des Transistors 21 von dem von den Redundanzdekodern $RD_v$ gelieferten Inhibitsignal Øk und das Gate des anderen Transistors 22 vom Taktsignal Ø1 beaufschlagt ist. Ferner ist durch die Source des Transistors 19 ein Knoten gegeben, der am Gate zweier weiterer Transistoren 23 und 24 sowie am einen Pol eines Kondensators C* liegt. Der andere Pol des Kondensators C* ist mit dem Sourceanschluß des Transistors 23 verbunden. Die Drainanschlüsse der Transistoren 23 und 24 liegen am Versorgungspotential $V_{DD}$ und ihre Sourceanschlüsse über je einen vom Ausgang des zweiten Inverters 16, 17 gesteuerten Transistor 25 bzw. 26 am Bezugspotential $V_{ss}$. Dabei ist dem die Verbindung zwischen dem Transistor 24 und dem Bezugspotential $V_{ss}$ bildenden Transistor 26 die Source-Drainstrecke eines durch das Inhibitsignal Øk gesteuerten Transistors 27 parallel geschaltet. Das für die Beaufschlagung der Normaldekoder $ND_\mu$ erforderliche Aktivierungssignal Ø3 wird von einem Knoten zwischen den Transistoren 24, 26 und 27 geliefert.

Die Normaldekoder $ND_\mu$ sind in der ebenfalls aus Fig. 3b ersichtlichen Weise gestaltet. Eine Anzahl p von mit ihrem Sourceanschluß am Bezugspotential $V_{ss}$ und über einen gemeinsamen Lasttransistor NT1 am Versorgungspotential $V_{DD}$ liegender MOS-Feldeffekttransistoren NT bilden das NOR-Gatter, das im Normaldekoder $ND_\mu$ enthalten ist. Dem Gate jedes dieser Transistoren NT ist je ein der zur Aktivierung des Normaldekoders $ND_\mu$ vorgesehener Adreßeingang $A_0$ oder $\bar{A}_0$, ...... $A_p$ oder $\bar{A}_p$ jeweils zugeordnet. Der Ausgang A' des NOR-Gatters, also der Knoten zwischen den Drains der parallel geschalteten Transistoren NT und der Source des — vom Taktsignal Ø1 gesteuerten — Lasttransistors NT1, ist wiederum an einen Transfertransistor NT2 gelegt, dessen Gate mit dem Versorgungspotential $V_{DD}$ verbunden ist und dessen anderer Anschluß zum Gate eines weiteren Transistors NT3 führt. Der Drainanschluß des Transistors NT3 ist vom Aktivierungssignal Ø3 beaufschlagt und ist deshalb mit dem Drain der Transistoren 26 und 27 sowie mit der Source des Transistors 24 verbunden. Der Sourceanschluß des Transistors NT3 liegt am einen Knoten eines RS-Flip-Flops FF3, dessen Fußpunkte am Bezugspotential $V_{ss}$ liegen und dessen zweiter Knoten über einen als Widerstand geschalteten Lasttransistor NR mit dem Versorgungspotential $V_{DD}$ verbunden ist.

Die RS-Flip-Flops FF1 und FF2 bei den einzelnen Redundanzdekodern $RD_v$ und das RS-Flip-Flop FF3 bei den einzelnen Normaldekodern $ND_\mu$ dienen der Sicherheit der Schaltung und könnten im Prinzip auch durch andere zu diesem Zweck übliche Schaltungen ersetzt werden. Der an dem vom Aktivierungssignal Ø3 an seinem Drain beaufschlagte Transistor NT3 bildet mit seinem am RS-Flip-Flop FF3 liegenden Sourceanschluß den Ausgang des Normaldekoders $ND_\mu$, der mit den Gates der von dem Normaldekoder $ND_\mu$ zu steuernden Transfertransistoren $Tr_\mu$ und $\bar{Tr}_\mu$ verbunden ist, die ihrerseits die Verbindung der dem Normaldekoder $ND_\mu$ zugeordneten und für den Normalbetrieb vorgesehenen Zeilen $nz_\mu$ und $\bar{nz}_\mu$ (bzw. Spalten) mit dem zugehörigen Dateneingang bzw. Datenausgang S/L bzw. $\bar{S}/\bar{L}$ bilden.

Es kann nun im Zusammenhang mit den Figuren 3, 3a, 3b und 3c folgendes Verhalten der erfindungsgemäßen Schaltung gezeigt werden:

Durch Auftrennen, beispielsweise mit Hilfe von Laserstrahlen, der Verbindungen F (also durch die bleibende Abänderung an einem beliebigen Redundanzdekoder $RD_v$) kann für jede redundante Zeile $ez_v$ entweder der Transistor T für die Adreßleitung $A_i$ oder der Transistor T für die Adreßleitung $\bar{A}_i$ (es gilt jeweils: $1 \leqslant i \leqslant p$) vom Dekoderknoten A abgetrennt werden und so eine Programmierung eines oder mehrerer Redundanzdekoder $RD_v$ erreicht werden. Es soll nun der Fall betrachtet werden, daß beide Redundanzdekoder $RD_v$ und $R_{v-1}$ in Fig. 3 programmiert sind. Außerdem wird angenommen, daß durch eine passende Adreßkombination der Redundanzdekoder $RD_v$ ausgewählt wird. Dies bedeutet, daß alle nach dem Auftrennen der entsprechenden Verbindungen F am Redundanzdekoder $RD_v$ noch anliegenden Adreßleitungen auf « Low » (=logisch « 0 ») liegen. Damit bleibt eine durch das Taktsignal Ø1 erzeugte Vorladung des Knotens A zwischen den Schalttransistoren T und dem Lasttransistor T1 des im betreffenden Redundanzdekoder $RD_v$ enthaltenen NOR-Gatters erhalten. Der Redundanzdekoder $RD_v$ ist somit aktiviert. Gleichzeitig ist aber auch einer der für den Normalbetrieb vorgesehenen Dekoder, z. B. der in Fig. 3b gezeigte Dekoder $ND_\mu$, aktiviert. Entsprechend dem in Fig. 3c gezeigten Taktschema erscheint zeitlich nach dem Auftreten des Adreßsignals $A_i$ bzw. $\tilde{A}_i$ und damit der Aktivierung des Redundanzdekoders $RD_v$ (Fig. 3) und des Normaldekoders $ND_\mu$ (Fig. 3b) die Aufwärtsflanke des Taktsignals $\emptyset 2$ und lädt über den Transistor T3 den das Inhibitsignal $\emptyset k$ liefernden Knoten C (Fig. 3) auf « high » (= logisch « 1 »). Durch den nach dem Taktsignal $\emptyset 2$ auf « high » geladenen und das Aktivierungssignal $\emptyset 3R$ liefernden Ausgang der in Fig. 3a dargestellten Schaltung wird die redundante Zeile $ez_v$ bzw. $\bar{e}\bar{z}_v$ ausgewählt. Durch die steigende Flanke des Inhibitsignals $\emptyset k$ wird eine ansteigende Flanke des von der Schaltung gemäß Fig. 3b zu erzeugenden Aktivierungssignales $\emptyset 3$ verhindert und damit ist der für den Normalbetrieb vorgesehene Dekoder $ND_\mu$ trotz der übereinstimmenden Adresse (z. B. der in Fig. 3b gezeigte Normaldekoder $ND_\mu$) nicht auswählbar.

Die Vorteile des erfindungsgemäßen Redundanzkonzepts sind ein im Vergleich zu der üblichen Lösung geringerer Platzverbrauch, da die regulären Dekoder $ND_\mu$ durch das Einfugen der Redundanz keine Änderung erfahren (Signal SS in Fig 1. Einsparen eines Eingangs je Normaldekoder $ND_\mu$. Außerdem wird auf vorteilhafte Weise eine Zeitersparnis gegenüber dem in Fig. 1 gezeigten Redundanzkonzept erreicht, weil durch geeignete Dimensionierung der in den Figuren 3, 3a, 3b und auch der in den Figuren 2 und 2a dargestellten vorteilhaften Schaltungen gewährleistet ist, daß das Aktivierungssignal $\emptyset 3$ auch dann deaktiviert bleibt, wenn das Inhibitsignal $\emptyset k$ erst nach einer etwa 1 ns betragenden Verzögerung gegenüber der Anstiegsflanke des Taktsignales $\emptyset 2$ auf « high » geht.

Das vorgeschlagene Redundanzkonzept ist erfindungsgemäß auch dann anwendbar, wenn für die Adressierung der Speicherzellen als Adreßdekoder sog. Mittendekoder verwendet werden sollen. Hierbei handelt es sich um Zellenfeldanordnungen, die in eine linke und eine rechte Zellenfeldhälfte aufgeteilt sind, bei denen der Adreßdekoder gleichzeitig zwei Bitleitungspaare auswählt. Eine Bitleitungspaar ist räumlich auf der einen Seite (linke Zellenfeldhälfte), das andere auf der anderen Seite (rechte Zellenfeldhälfte) des Mittendekoders angeordnet. Dies bedeutet, daß der Mittendekoder gleichzeitig zur Adressierung der entsprechenden Zeilen in beiden Hälften des gesamten Zellenfeldes zuständig ist. Die Zeilen können z. B. als « folded » Bitleitungen ausgeführt sein.

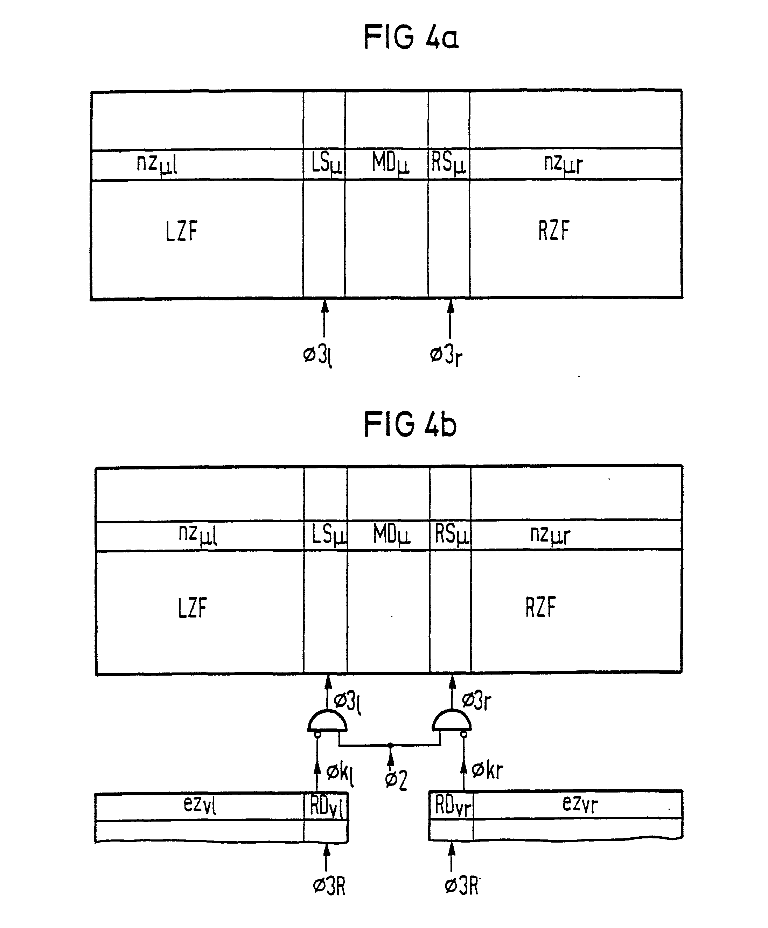

Das entsprechende, bekannte Platzaufteilungsschema ist in Fig. 4a gezeigt. Hier ist das Zellenfeld in eine linke Hälfte LZF und eine rechte Hälfte RZF unterteilt, zwischen denen sich eine Reihe der genannten Mittendekoder $MD_\mu$ erstreckt. Diese Mittendekoder $MD_\mu$ müssen, wie bereits bemerkt, sowohl auf die linke Zellenfeldhälfte LZF als auch auf die rechte Zellenfeldhälfte RZF einwirken, so daß je Mittendekoder $MD_\mu$ sowohl ein

linker « Schalter » $LS_\mu$ zur Adressierung in der linken Zellenfeldhälfte LZF als auch ein rechter « Schalter » $RS_\mu$ für die Adressierung in der rechten Zellenfeldhälfte RZF vorgesehen sind. Soll nun eine Redundanz und eine Ausgestaltung entsprechend der vorliegenden Erfindung vorgesehen sein, so ist es zweckmäßig, für die links und rechts angeordneten Redundanzzeilenhälften $ez_{vl}$, $ez_{vr}$ je einen der bereits beschriebenen Redundanzdekoder $RD_v$ zu verwenden, wie in Fig. 4b als Redundanzdekoder $RD_{vl}$, $RD_{vr}$ dargestellt.

Bei einer erfindungsgemäßen Ausgestaltung des für den Normalbetrieb vorgesehenen Speicherbereiches gemäß Fig. 4b, der die beiden Zellenfeldhälften LZF, RZF mit Normalzeilen $nz_\mu$ (aufgeteilt in eine linke ($nz_{\mu l}$) und eine rechte Normalzeilenhälfte ($nz_{\mu r}$) sowie je Normalzeile $nz_\mu$ einen Mittendekoder $MD_\mu$ und die beiden Schalter $LS_\mu$, $RS_\mu$ enthält, ist es aufgrund der vorteilhaften, noch zu beschreibenden Ausführung der Mittendekoder $MD_\mu$ samt den zugehörigen Schaltern $LS_\mu$, $RS_\mu$ in Verbindung mit der Verwendung zweier Redundanz dekoder $RD_{vl}$, $RD_{vr}$ einer redundanten Zeile $ez_{vl} + ez_{vr}$ von Vorteil, daß im Redundanzfall nicht eine komplette Normalzeile $nz_\mu$, sondern nur deren in der linken oder rechten Zellenfeldhälfte LZF, RZF liegende, defekte Zeilenhälfte ($nz_{\mu l}$, $nz_{\mu r}$) durch eine entsprechende linke ($ez_{vl}$) oder rechte ($ez_{vr}$) Hälfte einer redundanten Zeile $ez_{vl} + ez_{vr}$ ersetzt zu werden braucht. Damit läßt sich, bei angenommener gleichmäßiger Verteilung von Defekten in Normalzeilen $nz_\mu$ auf die beiden Zellenfeldhälften LZF, RZF die Anzahl der durch das erfindungsgemäße Redundanzkonzept « heilbaren » Defekte gegenüber bekannten Redundanzkonzepten bei gleicher Anzahl der zur Verfügung stehenden redundanten Zeilen $ez_{vl} + ez_{vr}$ verdoppeln.

Bei einem erfindungsgemäßen Schreib-Lesespeicher gemäß Fig. 4b werden die linken bzw. rechten Schalter $LS_\mu$, $RS_\mu$, die zwischen den Mittendekodern $MD_\mu$ und der linken bzw. rechten Zellenfeldhälfte LZF, RZF liegen, durch ein Aktivierungssignal $\emptyset 3_l$ bzw. $\emptyset 3_r$ aktiviert. Zweck und Ausgestaltung der beiden figurenmäßig nicht dargestellten, die Aktivierungssignale $\emptyset 3_l$, $\emptyset 3_r$ erzeugenden Schaltungen sind analog dem bereits beschriebenen Schaltungsteil in Fig. 3b, der dort das Aktivierungssignal $\emptyset 3$ erzeugt. Ein entsprechendes Logikschaltbild ist in Fig. 2a enthalten. Anstelle des dort verwendeten Inhibitsignales $\emptyset k$ wird jedoch zur Unterdrückung des Aktivierungssignales $\emptyset 3_l$ (l = zuständig für die linke Zellenfeldhälfte LZF) ein Inhibitsignal $\emptyset k_l$ verwendet. Analog dazu wird ein Inhibitsignal $\emptyset k_r$ zur Unterdrückung des Aktivierungssignales $\emptyset 3_r$ verwendet. Beide Inhibitsignale $\emptyset k_l$, $\emptyset k_r$ werden, analog der Schaltung gemäß Fig. 3, in den Redundanzdekodern $RD_{vl}$ bzw. $RD_{vr}$ erzeugt. Beide Redundanzdekoder $RD_{vl}$, $RD_{vr}$ sind mit den aus Fig. 3 bekannten Redundanzdekodern $RD_v$ schaltungstechnisch identisch.

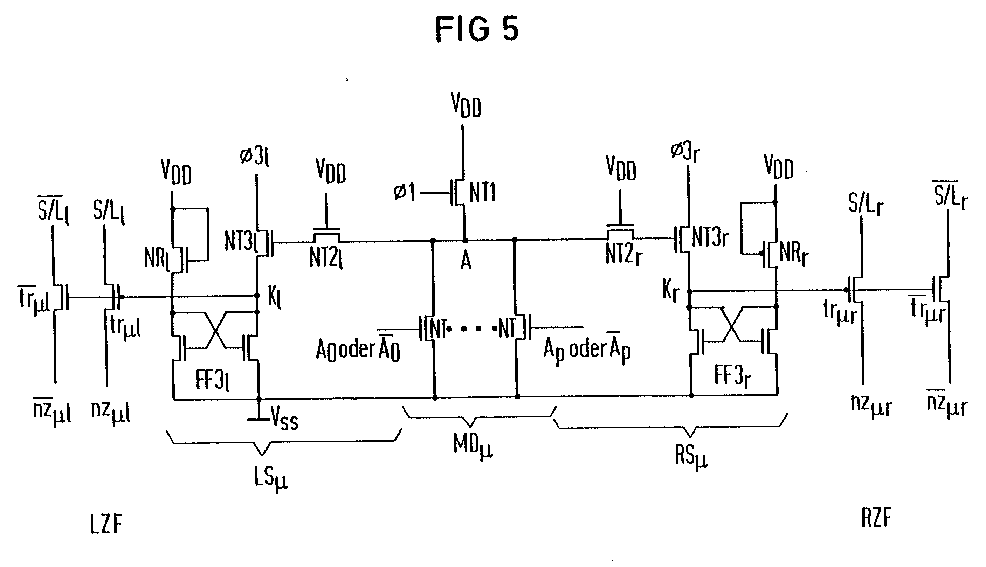

Gemäß Fig. 5 entspricht jeder der jeweils einer Zeile $nz_\mu$ des für den Normalbetrieb vorgesehenen und in die beiden Hälften LZF und RZF unterteilten Zellenfelds zugeordnete Mittendekoder $MD_\mu$ funktionell und schaltungstechnisch dem aus Fig. 3b bekannten NOR-Gatter samt zugehörigem Lasttransistor NTI eines Normaldekoders $ND_\mu$. Dem Mittendekoder $MD_\mu$ schließen sich nach links der linke Schalter $LS_\mu$ und nach rechts der rechte Schalter $RS_\mu$ an. Der Anschluß erfolgt jeweils über einen Transfertransistor $NT2_l$, $NT2_r$, wobei das Gate jedes Transfertransistors $NT2_l$, $NT2_r$ mit dem Versorgungspotential $V_{DD}$ verbunden ist.

Funktionell entsprechen die beiden Transfertransistoren $NT2_l$ bzw. $NT2_r$ dem aus Fig. 3b bekannten Transfertransistor NT2. Der Transfertransistor $NT2_l$ ist an seinem dem Mittendekoder $MD_\mu$ abgewandten stromführenden Anschluß mit dem Gate eines Transistors $NT3_l$ und der Transfertransistor $NT2_r$ in entsprechender Weise mit dem Gate eines Transistors $NT3_r$ verbunden. Die beiden Transistoren $NT3_l$ und $NT3_r$ entsprechen dem Transistor NT3 des in Fig. 3b gezeigten Normaldekoders $ND_\mu$ und sind dementsprechend an ihren Drainanschlüssen jeweils durch ein dem Aktivierungssignal Ø3 entsprechendes Aktivierungssignal $Ø3_l$ bzw. $Ø3_r$ beaufschlagt, dessen Erzeugung bereits beschrieben wurde. Ebenso ist das aus Fig. 3b bekannte RS-Flip-Flop FF3 zweimal — und zwar in Gestalt des RS-Flip-Flops $FF3_l$ und des RS-Flip-Flops $FF3_r$ — vertreten, wobei das RS-Flip-Flop $FF3_l$ im linken Schalter $LS_\mu$ und das RS-Flip-Flop $FF3_r$ im rechten Schalter $RS_\mu$ enthalten sind. Weitere sachliche Erörterungen zu der in Fig. 5 gezeigten Ausgestaltung des Mittendekoders $MD_\mu$ und der beiden Schalter $LS_\mu$, $RS_\mu$ samt deren Anschluß an die in der linken bzw. rechten Zellenfeldhälfte LZF bzw. RZF gelegene, für den Normalbetrieb vorgesehene Zeilenhälfte $nz_{\mu l}$ bzw. $nz_{\mu r}$ dürften aufgrund der Ausführungen zu Fig. 3b nicht mehr erforderlich sein.

Die Erfindung ist anwendbar sowohl auf statische als auch auf dynamische Schreib-Lesespeicher. Sie ist insbesondere auch auf dynamische Schreib-Lesespeicher anwendbar, deren Speicherzellen als Ein-Transistor-Speicherzellen aufgebaut sind.

**Patentansprüche**

1. Integrierter Schreib-Lesespeicher mit matrixförmig in Spalten und Zeilen angeordneten Speicherzellen, deren Adressierung über Adreßdekoder erfolgt, bei dem eine vorgegebene Zahl der Spalten und Zeilen $(nz_\mu)$ für einen Normalbetrieb und die restliche Zahl der Spalten und Zeilen $(ez_v)$ jeweils als Ersatz für jeweils eine Spalte bzw. Zeile der für den Normalbetrieb vorgesehenen Spalten bzw. Zeilen $(nz_\mu)$ vorgesehen sind, bei dem den einzelnen als Ersatz vorgesehenen Spalten bzw. Zeilen $(ez_v)$ zugeordnete Redundanzdekoder $(RD_v)$ derart ausgebildet und auf für den Normalbetrieb vorgesehene Normaldekoder $(ND_\mu)$ abgestimmt sind, daß eine Adressierung jeder der als Ersatz vorgesehenen Spalten bzw. Zeilen $(ez_v)$ erst nach einer bleibenden Änderung, Auftrennen einer Verbindung F, an dem ihnen jeweils zugeordneten Redundanzdekoder $(RD_v)$ möglich und außerdem diese Änderung mit einer Deaktivierung des den ersetzten Spalten bzw. Zeilen $(nz_\mu)$ jeweils zugeordneten Normaldekoders $(ND_\mu)$ verbunden ist, bei dem die den für den Normalbetrieb vorgesehenen Spalten bzw. Zeilen $(nz_\mu)$ jeweils zugeordneten Normaldekoder $(ND_\mu)$ so ausgestaltet sind, daß eine Auswahl eines dieser Normaldekoder $(ND_\mu)$ bei nicht gleichzeitig angesprochenem Redundanzdekoder $(RD_v)$ durch eine entsprechende Kombination von Adreßleitungen $(A_0, \bar{A}_0, ...., A_p, \bar{A}_p)$ und ein erstes, allen Normaldekodern $(ND_\mu)$ gemeinsames Aktivierungssignal (Ø3) erfolgt, bei dem die Redundanzdekoder $(RD_v)$ so ausgestaltet sind, daß eine Auswahl eines dieser Redundanzdekoder $(RD_v)$ zum Ersetzen einer der für den Normalbetrieb vorgesehenen Spalten bzw. Zeilen $(nz_\mu)$ durch die dem zu ersetzenden Normaldekoder $(ND_\mu)$ entsprechende Kombination von Adreßleitungen $(A_0, \bar{A}_0, ...; A_p, \bar{A}_p)$ und ein zweites, allen Redundanzdekodern $(RD_v)$ gemeinsames Aktivierungssignal (Ø3R) erfolgt, bei dem mit der Durchführung der bleibenden Änderung an einem oder mehreren Redundanzdekodern $(RD_v)$ und bei einer Auswahl eines dieser Redundanzdekoder $(RD_v)$ ein Inhibitsignal (Øk) erzeugt wird, das dazu dient, die für das Ansprechen der Normaldekoder $(ND_\mu)$ notwendige Pegeländerung des genannten Aktivierungssignales (Ø3) zu verhindern, dadurch gekennzeichnet, daß das von aktivierten Redundanzdekodern $(RD_v)$ gelieferte Inhibitsignal (Øk) gemeinsam mit einem ersten und einem zweiten Taktsignal (Ø1, Ø2) zur Steuerung einer das erste Aktivierungssignal (Ø3) für die Normaldekoder $(ND_\mu)$ liefernde und aus selbstsperrenden MOS-Feldeffekttransistoren (14 bis 27) sowie einem weiteren Kondensator (C*) gebildeten Schaltung vorgesehen ist, daß diese Schaltung derart ausgebildet ist, daß mit dem Auftreten des Inhibitsignales (Øk) die Entstehung des ersten Aktivierungssignales (Ø3) dann unterdrückt wird, wenn gleichzeitig mit der Adressierung des die Entstehung des Inhibitsignales (Øk) bewirkenden Redundanzdekoders $(RD_v)$ ein Normaldekoder $(ND_\mu)$ adressiert wird.

2. Schreib-Lesespeicher nach Anspruch 1, dadurch gekennzeichnet, daß die aus den selbstsperrenden MOS-Feldeffekttransistoren (14 bis 27) vom selben Kanaltyp gebildete Schaltung derart ausgestaltet ist, daß ein erster Inverter, gebildet aus einem durch das erste Taktsignal (Ø1) gesteuerten Schalttransistor (14) und einem durch das zweite Taktsignal (Ø2) gesteuerten Lasttransistor (15) mit seinem Ausgang den Schalttransistor (16) eines zweiten Inverters steuert, dessen Lasttransistor (17) mit seinem Gate durch das erste Taktsignal (Ø1) beaufschlagt ist, daß der Ausgang des zweiten Inverters (16, 17) über die Source-Drainstrecke eines vom zweiten Taktsignal (Ø2) gesteuerten Transfertransistors (18) einerseits mit dem Gate eines — an seinem Drain durch das zweite Taktsignal (Ø2) beaufschlagten — weiteren Transistors (19) verbunden und andererseits über die Source-Drainstrecke eines durch das Inhibitsignal (Øk) gesteuerten Entladungstransistors (20) mit dem Bezugspotential ($V_{ss}$) verbunden ist, daß dabei der über den genannten Transfertransistor (18) vom Ausgang des zweiten Inverters (16, 17) an seinem Gate beaufschlagte Transistor (19) mit seiner Source einerseits über die Parallelschaltung eines von dem Inhibitsignal (Øk) gesteuerten Transistors (21) mit einem durch das erste Taktsignal (Ø1) gesteuerten Transistor (22) mit dem Bezugspotential ($V_{ss}$) verbunden und andererseits an den einen Pol des weiteren Kondensators (C*) sowie an die Gates zweier — mit ihrem Drain am Versorgungspotential ($V_{DD}$) liegender — Lade-Transistoren (23, 24) gelegt ist, daß dabei der andere Pol des weiteren Kondensators (C*) sowohl mit der Source des einen der beiden Lade-Transistoren (23) und dem Drain eines weiteren — mit seiner Source am Bezugspotential ($V_{ss}$) liegenden — Transistors (25) verbunden ist, daß dieser letztgenannte Transistor (25) an seinem Gate vom Ausgang des zweiten Inverters (16, 17) gesteuert wird, daß die Source des anderen Ladetransistors (24) über die Parallelschaltung zweier weiterer Transistoren (26, 27) in Serie zu dem Bezugspotential ($V_{ss}$) liegt, wobei der eine dieser Transistoren (27) durch das Inhibitsignal (Øk) und der andere Transistor (26) durch den Ausgang des zweiten Inverters (16, 17) gesteuert ist, und daß das erste Aktivierungssignal (Ø3) für die Normaldekoder ($ND_\mu$) an einem Schaltungspunkt entsteht, der zwischen den Drainanschlüssen der beiden letztgenannten Transistoren (26, 27) und dem Sourceanschluß des anderen Ladetransistors (24) liegt.

3. Schreib-Lesespeicher nach Anspruch 1 oder 2, dadurch gekennzeichnet, daß zur Erzielung der Freigabe der Verbindung zwischen dem Dateneingang bzw. Datenausgang (S/L bzw. $\bar{S}/\bar{L}$) der für den Normalbetrieb vorgesehenen Zeilen ($nz_\mu$) eine Schaltung verwendet wird, die folgendermaßen aufgebaut ist :

a) eine Menge p von Transistoren (NT) (p = Anzahl der Adreßleitungen $A_0$ bis $A_p$ bzw. $\bar{A}_0$ bis $A_p$) ist nach Art eines NOR-Gatters in einem Normaldekoder ($ND_\mu$) parallel geschaltet, wobei jeder der Transistoren (NT) von einer Adreßleitung ($A_0$ oder $\bar{A}_0$, ..., $A_p$ oder $\bar{A}_p$) aus einer Gesamtmenge der Adreßleitungen ($A_0$, $\bar{A}_0$, ..., $A_p$, $\bar{A}_p$) an seinem Gate angesteuert wird, wobei die Sourceanschlüsse aller dieser Transistoren (NT) mit dem Bezugspotential ($V_{ss}$) verbunden sind, und wobei die Drainanschlüsse aller dieser Transistoren (NT) zu einem Schaltungspunkt (A') verknüpft sind,

b) dieser Schaltungspunkt (A') ist über die Source-Drainstrecke eines weiteren Transistors (NT1) mit dem Versorgungspotential ($V_{DD}$) verbunden, wobei eine Ansteuerung des Gates dieses weiteren Transistors (NT1) durch das erste Taktsignal (Ø1) ein Vorladen dieses Schaltungspunktes auf das Versorgungspotential ($V_{DD}$) bewirkt,

c) dieser Schaltungspunkt (A') ist des weiteren über die Source-Drainstrecke eines gatemäßig an das Versorgungspotential ($V_{DD}$) an geschlossenen Quertransistors (NT2) mit dem Gate eines Schalttransistors (NT3) verbunden,

d) dieser Schalttransistor (NT3) wird an seinem Drainanschluß mit dem ersten Aktivierungssignal (Ø3) angesteuert, sein Sourceanschluß bildet einerseits den Gateanschluß zweier Transistoren ($Tr_\mu$, $\bar{Tr}_\mu$), die die Freigabe der Verbindung zwischen dem Dateneingang bzw. Datenausgang (S/L bzw. $\bar{S}/\bar{L}$) der für den Normalbetrieb vorgesehenen Zeilen ($nz_\mu$) bewirken, andererseits bildet er einen Anschluß an die Drain des einen Transistors eines zwei kreuzgekoppelte Transistoren enthaltenden RS-Flip-Flops (FF3) und das Gate des anderen Transistors dieses RS-Flip-Flops (FF3),

e) der andere Transistor dieses RS-Flip-Flops (FF3) ist mit seinem Sourceanschluß sowohl mit dem Gate des einen Transistors des RS-Flip-Flops (FF3) als auch über die Source-Drainstrecke eines Lasttransistors (NR) mit dem Versorgungspotential ($V_{DD}$) verbunden, verbunden, wobei das Gate dieses Lasttransistors (NR) ebenfalls an das Versorgungspotential ($V_{DD}$) angeschlossen ist,

f) die Sourceanschlüsse der beiden Transistoren, die das RS-Flip-Flop (FF3) bilden, sind mit dem Bezugspotential ($V_{ss}$) verbunden.

4. Schreib-Lesespeicher nach einem der Ansprüche 1 bis 3, dadurch gekennzeichnet, daß sowohl jeder der Normaldekoder ($ND_\mu$) als auch jeder der Redundanzdekoder ($RD_v$) mindestens ein NOR-Gatter beinhält, daß im Falle der Normaldekoder ($ND_\mu$) jeweils die entsprechende Kombination von Adreßleitungen ($A_0$, $\bar{A}_0$, ... $A_p$, $\bar{A}_p$) Signaleingänge für die NOR-Gatter bildet, daß im Falle der Redundanzdekoder ($RD_v$) alle Adreßleitungen ($A_0$, $\bar{A}_0$ ... $A_p$, $\bar{A}_p$) Signaleingänge für die NOR-Gatter bilden, wobei jeder dieser Signaleingänge jedes NOR-Gatters der Redundanzdekoder ($RD_v$) über eine auftrennbare Verbindung (F) mit der jeweils zugehörigen Adreßleitung ($A_0$, $\bar{A}_0$ ... $A_p$, $\bar{A}_p$) verbunden ist, daß die Ausgänge der NOR-Gatter der Normaldekoder ($ND_\mu$) zur Steuerung jeweils eines ersten UND-Gatters ($U_\mu$⁻ bzw. NT3) vorgesehen sind, daß die Ausgänge der NOR-Gatter der Redundanzdekoder ($RD_v$) zur Steuerung jeweils eines zweiten UND-Gatters ($U_v$* bzw. T4) vorgesehen sind, daß diese UND-Gatter ($U_\mu$⁻ bzw. NT3 ; $U_v$* bzw. T4) jeweils von einem der beiden Aktivierungssignale (Ø3 bzw. Ø3R) mitgesteuert werden und ihrerseits zu einer Freigabe einer Verbindung zwischen einem Dateneingang bzw. Datenausgang (S/L bzw. $\bar{S}/\bar{L}$) und der zu dem betreffenden Normaldekoder ($ND_\mu$) bzw. Redundanzdekoder ($RD_v$) gehörenden Zeilen ($nz_\mu$ bzw. $ez_v$) bzw. Spalten dient, daß weiterhin des NOR-Gatter jedes einzelnen Redundanzdekoders ($RD_v$) zusammen mit dem allen Redundanzdekodern ($RD_v$) gemeinsamen zweiten Taktsignal (Ø2) ein drittes UND-Gatter ($U_v$ bzw. T3) steuert, dessen Ausgangssignal als Inhibitsi-

gnal (Øk) Einfluß auf das für die Freigabe der Verbindung zwischen dem Dateneingang bzw. dem Datenausgang (S/L, S̄/L̄) und den den Normaldekodern (ND$_\mu$) jeweils zugeordneten Spalten bzw. Zeilen (nz$_\mu$) notwendige erste Aktivierungssignal (Ø3) im Sinne einer Inaktivierung dieses ersten Aktivierungssignals (Ø3), insbesondere in Form einer Unterdrückung desselben nimmt.

5. Schreib-Lesespeicher nach einem der Ansprüche 1 bis 4, dadurch gekennzeichnet, daß die in den Normaldekodern (ND$_\mu$) und die in den Redundanzdekodern (RD$_v$) vorgesehenen ersten, zweiten und dritten UND-Gatter (U$^-_\mu$, U$_v$*, U$_v$) jeweils zwei Signaleingänge besitzen, wobei der eine Signaleingang jeweils durch den Ausgang des mit den Adreßleitungen (A$_0$, Ā$_0$, ... A$_p$, Ā$_p$) beaufschlagten NOR-Gatters und der andere Eingang des ersten bzw. zweiten UND-Gatters (U$_\mu$. bzw. U$_v$*) im Falle der Normaldekoder (ND$_\mu$) durch das allen Normaldekodern (ND$_\mu$) gemeinsame erste Aktivierungssignal (Ø3) und im Falle der Redundanzdekoder (RD$_v$) durch das allen Redundanzdekodern (RD$_v$) gemeinsame zweite Aktivierungssignal (Ø3R) beaufschlagt ist, daß außerdem das im Falle der einzelnen Redundanzdekoder (RD$_v$) jeweils vorgesehene dritte UND-Gatter (U$_v$) an seinem zweiten Eingang durch das zweite Taktsignal (Ø2) beaufschlagt ist, daß am Ausgang dieses dritten UND-Gatters (U$_v$) ein — nach Programmierung des betreffenden Redundanzdekoders (RD$_v$) aufgrund seiner dann möglichen Adressierung entstehendes — Signal zur Verfügung steht, welches unter Vermittlung eines allen Redundanzdekodern gemeinsamen, weiteren ODER-Gatters (OG), welches von den Ausgängen aller dritten UND-Gatter (U$_v$) der Redundanzdekoder (RD$_v$) eingangsseitig angesteuert wird, wodurch am Ausgang dieses weiteren ODER-Gatters (OG) das Inhibit-Signal (Øk) erzeugt wird.

6. Schreib-Lesespeicher nach einem der Ansprüche 1 bis 5, dadurch gekennzeichnet, daß das am Ausgang des ODER-Gatters (OG) entstehende Inhibitsignal (Øk) unter Vermittlung eines Inverters an einen Eingang eines vierten UND-Gatters (U**) gelegt und daß ein anderer Eingang dieses vierten UND-Gatters (U**) durch das zweite Taktsignal (Ø2) beaufschlagt ist, wodurch am Ausgang dieses vierten UND-Gatters (U**) das zur Aktivierung des in den einzelnen Normaldekodern (ND$_\mu$) jeweils vorgesehenen ersten UND-Gatters (U$_\mu^-$) dienende und für alle Normaldekoder (ND$_\mu$) gemeinsame erste Aktivierungssignal (Ø3) entsteht.

7. Schreib-Lesespeicher nach einem der vorhergehenden Ansprüche, dadurch gekennzeichnet, daß in den einzelnen Redundanzdekodern (RD$_v$) jedem Adreßeingang (A$_0$, Ā$_0$ ... A$_p$, Ā$_p$) jeweils ein selbstsperrender MOS-Feldeffekttransistor (T) zugeordnet ist, der je einen Schalttransistor des NOR-Gatters des betreffenden Redundanzdekoders (RD$_v$) bildet und dessen Drain über eine auftrennbare Verbindung-(F) an den Sourceanschluß eines gemeinsamen Lasttransistors (T1) und damit an einen Ausgang (A) des durch die genannten Transistoren (T) gebildeten NOR-Gatters gelegt ist, daß ferner der Ausgang (A) des NOR-Gatters über einen an seinem Gate am Versorgungspotential (V$_{DD}$) des NOR-Gatters liegenden Transistors (T2) an das Gate zweier weiterer Transistoren (T3, T4) gelegt ist, deren Sourceanschluß jeweils über eine Sicherungsschaltung (FF1, FF2) mit dem Bezugspotential (V$_{SS}$) des NOR-Gatters verbunden ist und deren Drainanschlüsse im Falle des einen Transistors (T4) durch das gemeinsame zweite Aktivierungssignal (Ø3R) der Redundanzdekoder (RD$_v$) und im Falle des anderen Transistors (T3) durch das zur Mitsteuerung des dritten UND-Gatters (U$_v$) in den Redundanzdekodern (RD$_v$) vorgesehene zweite Taktsignal (Ø2) beaufschlagt sind, während die Source des an seiner Drain durch das zweite Aktivierungssignal (Ø3R) beaufschlagten einen Transistors (T4) die Freigabe der Verbindung zwischen dem Dateneingang bzw. Datenausgang (S/L bzw. S̄/L̄) und der zu dem betreffenden Redundanzdekoder (RD$_v$) gehörenden redundanten Spalten bzw. Zeilen (ez$_v$, ēz̄$_v$) steuernden Ausgang des Redundanzdekoders (RD$_v$) bildet während der das dritte UND-Gatter (U$_v$) des Redundanzdekoders (RD$_v$) darstellende und vom zweiten Taktsignal (Ø2) gesteuerte andere Transistor (T3) an seinem Sourceanschluß das die Inaktivierung des ersten Aktivierungssignales (Ø3) nach Auswahl eines entsprechenden Redundanzdekoders (RD$_v$) bewirkende Inhibit-Signal (Øk) zur Verfügung stellt.

8. Schreib-Lesespeicher nach einem der Ansprüche 1 bis 7, dadurch gekennzeichnet, daß die Sicherungsschaltungen (FF1, FF2), die an jeweils einem ersten Knoten mit dem Sourceanschluß der beiden, je ein UND-Gatter darstellenden Transistoren (T3, T4) direkt verbunden sind, durch je ein RS-Flip-Flop (FF1, FF2) gegeben sind, deren Fußpunkte jeweils mit dem Bezugspotential (V$_{SS}$) des den Redundanzdekoder (RD$_v$) bildenden NOR-Gatters verbunden sind, während ein zweiter Knoten jedes der beiden Flip-Flops (FF1, FF2) jeweils über einen als Widerstand geschalteten MOS-Feldeffekttransistor (R) mit dem Versorgungspotential (V$_{DD}$) des Redundanzdekoders (RD$_v$) verbunden sind.

9. Schreib-Lesespeicher nach einem der Ansprüche 1 bis 8, dadurch gekennzeichnet, daß zur Erzeugung des für die vorgesehenen Redundanzdekoder (RD$_v$) gemeinsam dienenden zweiten Aktivierungssignals (Ø3R) eine aus zwölf selbstsperrenden MOS-Feldeffekttransistoren (1 bis 12) und einem Kondensator (C) bestehende Schaltung sowie zu deren Betrieb das erste und das zweite Taktsignal (Ø1, Ø2) vorgesehen sind, daß dabei der erste Transistor (1) mit seiner Source am Bezugspotential (V$_{SS}$), mit seinem Gate am ersten Taktsignal (Ø1) und mit seinem Drain sowohl über einen vom zweiten Taktsignal (Ø2) gesteuerten zweiten Transistor (2) am Versorgungspotential (V$_{DD}$) liegt als auch mit dem Gate eines dritten Transistors (3) verbunden ist, daß dabei der dritte Transistor (3) zusammen mit einem vierten Transistor (4) eine zwischen dem Versorgungspotential (V$_{DD}$) und dem Bezugspo-

tential ($V_{ss}$) liegende weitere Reihenschaltung bildet, bei der der mit seinem Drain am Versorgungspotential ($V_{DD}$) liegende vierte Transistor (4) durch das erste Taktsignal (Ø1) gesteuert wird, daß ein zwischen dem dritten und dem vierten Transistor (3, 4) liegender Schaltungspunkt über die Source-Drainstrecke eines an seinem Gate vom zweiten Taktsignal (Ø2) gesteuerten fünften Transistors (5) sowohl mit dem Gate eines an seinem Drain durch das zweite Taktsignal (Ø2) beaufschlagten sechsten Transistors (6) als auch über einen weiteren Transistor (12), der von dem ersten Taktsignal (Ø1) gesteuert ist, mit dem Versorgungspotential ($V_{DD}$) verbunden ist daß außerdem der Source Anschluß des sechsten Transistors (6) einerseits mit dem Gate eines weiteren Transistors (7) verbunden ist, dessen Drain am Versorgungspotential ($V_{DD}$) liegt und dessen Source zum einen mit dem eigenen Gate über den Kondensator (C) verbunden ist und zum anderen mit dem Drain eines weiteren Transistors (9) verbunden ist, dessen Source mit dem Bezugspotential ($V_{ss}$) verbunden ist, und dessen Gate wiederum mit dem Schaltungspunkt zwischen dem dritten und vierten Transistor (3, 4) verbunden ist, daß außerdem der Sourceanschluß des sechsten Transistors (6) mit dem Drainanschluß eines weiteren Transistors (10), der durch das erste Taktsignal (Ø1) gesteuert ist, mit dem Bezugspotential ($V_{ss}$) verbunden ist, daß ferner der Sourceanschluß des sechsten Transistors (6) am Gate eines weiteren Transistors (8) liegt, dessen Drain am Versorgungspotential ($V_{DD}$) und dessen Source sowohl den das zweite Aktivierungssignal (Ø3R) für die Redundanzdekoder ($RD_v$) liefernden Ausgang bildet als auch über einen weiteren Transistor (11) mit dem Bezugspotential ($V_{ss}$) verbunden ist, wobei das Gate dieses Transistors (11) ebenfalls mit dem zwischen dem dritten und dem vierten Transistor (3, 4) liegenden Schaltungspunkt beaufschlagt ist, und bei dem schließlich die beiden Taktsignale (Ø1, Ø2) derart ausgebildet sind, daß die fallende Flanke des ersten Taktsignales (Ø1) zeitlich unmittelbar vor dem Auftreten der Adressierungssignale ($A_0$, $\bar{A}_0$, ...., $A_p$, $\bar{A}_p$) liegt, während das zweite Taktsignal (Ø2) mit dem zur Mitsteuerung des dritten UND-Gatters ($U_v$) in den einzelnen Redundanzdekodern ($RD_v$) gemeinsamen zweiten Taktsignal (Ø2) identisch ist.

10. Schreib-Lesespeicher nach mindestens einem der vorhergehenden Ansprüche mit einer Aufteilung der für den Normalbetrieb vorgesehenen Spalten bzw. Zeilen ($nz_\mu$) in eine linke (LZF) und eine rechte Zellenfeldhälfte (RZF), mit einer Ausgestaltung der zugehörigen Normaldekoder ($ND_\mu$) nach Art von Mittendekodern ($MD_\mu$) die mit der linken bzw. rechten Zellenfeldhälfte (LZF, RZF) jeweils mit einem linken bzw. rechten Schalter ($LS_\mu$, $RS_\mu$) verbunden sind, wobei die linken bzw. rechten Schalter ($LS_\mu$, $RS_\mu$) jeweils über ein linkes bzw. rechtes Aktivierungssignal (Ø3$_l$ bzw. Ø3$_r$) angesteuert werden, dadurch gekennzeichnet, daß die als Ersatz vorgesehene Spalten bzw. Zeilen ($ez_v$) ebenfalls jeweils in eine linke Zeilenhälfte ($ez_{vl}$) und eine rechte Zeilenhälfte ($ez_{vr}$) aufgeteilt sind, daß jede dieser Zeilenhälften ($ez_{vl}$, $ez_{vr}$) über einen eigenen linken bzw. rechten Redundanzdekoder ($RD_{vl}$, $RD_{vr}$) ausgewählt wird, und daß das linke bzw. rechte Aktivierungssignal (Ø3$_l$, Ø3$_r$) analog erzeugt wird zu dem ersten Aktivierungssignal (Ø3) für Normaldekoder ($ND_\mu$).

11. Schreib-Lesespeicher nach Anspruch 10, dadurch gekennzeichnet, daß zur Erzeugung des linken bzw. rechten Aktivierungssignals (Ø3$_l$, Ø3$_r$) jeweils ein Inhibitsignal (Ø$k_l$, Ø$k_r$) verwendet wird, das von den linken bzw. rechten Redundanzdekodern ($RD_{vl}$, $RD_{vr}$) analog erzeugt wird zu dem Inhibitsignal (Ø$k$), das das Auftreten des ersten Aktivierungssignales (Ø3) bei Normaldekodern ($ND_\mu$) ggf. unterdrückt.

12. Schreib-Lesespeicher nach Anspruch 10 oder 11, gekennzeichnet durch

a) Mittendekoder ($MD_\mu$, die jeweils ein NOR-Gatter enthalten, das in Form von p parallel geschalteten MOS-Transistoren (NT ; p = Anzahl der Adreßleitungen $A_0$ ... $A_p$ bzw. deren Komplementleitungen $\bar{A}_0$ ... $\bar{A}_p$) realisiert ist, wobei jedes Gate der MOS-Transistoren durch eine Adreßleitung ($A_0$ ... $A_p$) oder deren komplementärer Adreßleitung ($\bar{A}_0$ ... $\bar{A}_p$) gesteuert wird, die Sourceanschlüsse mit dem Bezugspotential ($V_{ss}$) verbunden sind und ein Schaltungspunkt (A), gebildet aus den Drainanschlüssen aller parallel geschalteten MOS-Transistoren (NT) des NOR-Gatters, über die Source-Drainstrecke eines vom ersten Taktsignal (Øl) gesteuerten Schalttransistors (NTI) mit dem Versorgungs-potential ($V_{DD}$) verbunden ist,

b) sich nach links bzw. rechts an jeden Mittendekoder ($MD_\mu$) anschließenden Schalter ($LS_\mu$ bzw. $RS_\mu$), der einen Quertransistor (NT2$_l$ bzw. NT2$_r$) enthält, der gatemäßig mit dem Versorgungspotential ($V_{DD}$) verbunden ist und dessen stromführende Pfade (Source bzw. Drain) einerseits an den Schaltungspunkt (A) des Mittendekoders ($MD_\mu$) angeschlossen sind und andererseits den Gateanschluß eines weiteren Schalttransistors (NT3$_l$ bzw. NT3$_r$) bilden, wobei an der Drain dieses Schalttransistors (NT3$_l$, NT3$_r$) das linke bzw. rechte Aktivierungssignal (Ø3$_l$, Ø3$_r$) eingespeist wird und wobei der Sourceanschluß einen Schaltungsknoten ($K_l$ bzw. K) bildet, der zum einen an die linke bzw. rechte Zellenfeldhälfte (LZF, RZF) angeschlossen ist in der Form, daß er mit den Gates von zwei Transistoren ($tr_{\mu l}$, $\bar{tr}_{\mu l}$ ; $tr_{\mu r}$, $\bar{tr}_{\mu r}$) verbunden ist, die die Freigabe der Verbindung zwischen dem Dateneingang bzw. Datenausgang (S/$L_l$, $\bar{S}$/$\bar{L}_l$ ; S/$L_r$, $\bar{S}$/$\bar{L}_r$) und der für den Normalbetrieb vorgesehenen linken bzw. rechten Zeilenhälfte ($nz_{\mu l}$, $nz_{\mu r}$) bewirken, und daß dieser Schaltungsknoten ($K_l$ bzw. $K_r$) zum anderen mit einem in üblicher Weise aus zwei kreuzgekoppelten Transistoren gebildeten RS-Flip-Flop (FF3$_l$ bzw. FF3$_r$) so verbunden ist, daß dieser Schaltungsknoten ($K_l$ bzw. $K_r$) sowohl den Drainanschluß des einen kreuzgekoppelten Transistors bildet als auch den Gateanschluß des anderen kreuzgekoppelten Transistors, wobei die Sourceanschlüsse dieser beiden Transistoren mit dem Bezugspotential (V$_{ss}$) verbunden sind und sowohl der Gateanschluß des einen Transistors als auch der Drainanschluß des anderen Transistors über einen als Widerstand geschalteten, weiteren Transistor (NR$_l$, NR$_r$) mit dem Versorgungspotential (V$_{DD}$) verbunden sind.

## Claims

1. Integrated write-read memory having memory cells arranged in matrix fashion in columns and rows, said cells being addressed via address decoders, in which a predetermined number of the columns and rows (nz$_\mu$) are provided for a normal operation and the remaiming number of the columns and rows (ez$_v$) are provided in each case as a substitute for in each case one column or row of the columns and rows (nz$_\mu$) respectively provided for the normal operation, in which the individual redundancy decoders (RD$_v$) associated with columns and rows (ez$_v$) provided as a substitute are designed in such a manner and matched to normal decoders (ND$_\mu$) provided for the normal operation in such a manner that addressing of each of the columns or rows (ez$_v$) provided as a substitute is only possible after a permanent change, separation of a connection F, on the respective redundancy decoder (RD$_v$) associated therewith and, moreover, this change is connected with a deactivation of the normal decoder (ND$_\mu$) associated in each case with the substituted columns or rows (nz$_\mu$), in which the normal decoders (ND$_\mu$) in each case associated with the columns and rows (nz$_\mu$) provided for the normal operation are organized in such a manner that one of these normal decoders (ND$_\mu$) is selected, when the redundancy decoder (RD$_v$) is not simultaneously activated, by a corresponding combination of address lines (A$_0$, Ā$_0$, ..., A$_p$, Ā$_p$) and a first activation signal (Ø3) common to all normal decoders (ND$_\mu$), in which the redundancy decoders (RD$_v$) are organized in such a manner that one of these redundancy decoders (RD$_v$) is selected for substituting one of the columns or rows (nz$_\mu$) provided for the normal operation by the combination of address lines (A$_0$, A$_0$, ..., A$_p$, A$_p$) corresponding to the normal decoder (ND$_\mu$) to be substituted and a second activation signal (Ø3R) common to all redundancy decoders (RD$_v$), in which, with the execution of the permanent change at one or more redundancy decoders (RD$_v$) and upon a selection of one of these redundancy decoders (RD$_v$), an inhibit signal (Øk) is generated which serves to prevent the level change of said activation signal (Ø3) necessary for activating the normal decoders (ND$_\mu$), characterized in that the inhibit signal (Øk) supplied by activated redundancy decoders (RD$_v$) is provided together with a first and a second clock signal (01, 02) for controlling a circuit which supplies the first activation signal (Ø3) for the normal decoders (ND$_\mu$) and which is formed by normally-off MOS field-effect transistors (14 to 27) and a further capacitor (C*), in that this circuit is designed in such a manner that when the inhibit signal (Øk) occurs the generation of the first activation signal (Ø3) is suppressed when a normal decoder (ND$_\mu$) is addressed at the same time as the redundancy decoder (RD$_v$) causing the generation of the inhibit signal (Øk) is addressed.

2. Write-read memory according to Claim 1, characterized in that the circuit formed by the normally-off MOS field-effect transistors (14 to 27) of the same channel type is designed in such a manner that a first inverter, formed by a switching transistor (14) controlled by the first clock signal (Ø1) and a load transistor (15) controlled by the second clock signal (Ø2), controls with its output the switching transistor (16) of a second inverter, the load transistor (17) of which receives the first clock signal (Ø1) with its gate, in that the output of the second inverter (16, 17) is connected on the one hand via the source-drain path of a transfer transistor (18) controlled by the second clock signal (Ø2) to the gate of a further transistor (19), which receives the second clock signal (Ø2) at its drain, and on the other hand via the source-drain path of a discharging transistor (20) controlled by the inhibit signal (Øk) to the reference potential (V$_{ss}$), in that the transistor (19) receiving at its gate the output of the second inverter (16, 17) via said transfer transistor (18) is thereby connected with its source on the one hand via the parallel connection of a transistor (21), controlled by the inhibit signal (Øk), with a transistor (22), controlled by the first clock signal (Ø1), to the reference potential (V$_{ss}$), and on the other hand is connected to one pole of the further capacitor (C*) as well as to the gates of two load transistors (23, 24), lying with their drain at the supply potential (V$_{DD}$), in that the other pole of the further capacitor (C*) is thereby connected both to the source of one of the two load transistors (23) and to the drain of the further transistor (25), lying with its source at the reference potential (V$_{ss}$), in that this last-mentioned transistor (25) is controlled at its gate by the output of the second inverter (16, 17), in that the source of the other load transistor (24) lies via the parallel connection of two further transistors (26, 27) in series to the reference potential (V$_{ss}$), one of these transistors (27) being controlled by the inhibit signal (Øk) and the other transistor (26) being controlled by the output of the second inverter (16, 17), and in that the first activation signal (Ø3) for the normal decoders (ND$_\mu$) is generated at a circuit point which lies between the drain connections of the two last-mentioned transistors (26, 27) and the source connection of the other load transistor (24).

3. Write-read memory according to Claim 1 or 2, characterized in that, for achieving the release of the connection between the data input or data output (S/L or S̄/L̄ respectively) of the rows (nz$_\mu$) provided for the normal operation, a circuit is employed which is designed as follows :

a) A quantity p of transistors (NT) (p = number of address lines A$_0$ to A$_p$ or Ā$_0$ to

$\bar{A}_p$) is connected in parallel in the manner of a NOR gate in a normal decoder ($ND_\mu$), each of the transistors (NT) being driven by an address line ($A_0$ or $\bar{A}_0$, ..., $A_p$ or $\bar{A}_p$) from a total quantity of the address lines ($A_0$, $\bar{A}_0$, ..., $A_p$, $\bar{A}_p$) at its gate, the source connections of all these transistors (NT) being connected to the reference potential ($V_{ss}$), and the drain connections of all these transistors (NT) being combined to a circuit point (A'),

b) this circuit point (A') is connected via the source-drain path of a further transistor (NT1) to the supply potential ($V_{DD}$), a driving of the gate of this further transistor (NT1) by the first clock signal (Ø1) causing a precharging of this circuit point to the supply potential ($V_{DD}$),

c) this circuit point (A') is furthermore connected via the source-drain path of a transverse transistor (NT2), connected via its gate to the supply potential ($V_{DD}$), to the gate of a switching transistor (NT3),

d) this switching transistor (NT3) is driven at its drain connection by the first activation signal (Ø3) ; its source connection forms on the one hand the gate connection of two transistors ($Tr_\mu$, $\bar{T}r_\mu$) which effect the release of the connection between the data input or data output (S/L or $\bar{S}/\bar{L}$ respectively) of the rows ($nz_\mu$) provided for the normal operation, on the other hand it forms a connection to the drain on one transistor of an Rs flipflop (FF3) containing two cross-coupled transistors and the gate of the other transistor of this RS flipflop (FF3),

e) the other transistor of this RS flipflop (FF3) is connected with its source connection both to the gate of one transistor of the RS flipflop (FF3) and, via the source-drain path of a load transistor (NR), to the supply potential ($V_{DD}$), the gate of this load transistor (NR) likewise being connected to the supply potential ($V_{DD}$),

f) the source connections of both transistors which form the RS flipflop (FF3) are connected to the reference potential ($V_{ss}$).

4. Write-read memory according to one of Claims 1 to 3, characterized in that each of the normal decoders ($ND_{/u}$) as well as each of the redundancy decoders ($RD_v$) contains at least one NOR gate, in that in the case of the normal decoders ($ND_\mu$) in each case the corresponding combination of address lines ($A_0$, $\bar{A}_0$, ... $A_p$, $\bar{A}_p$) forms signal inputs for the NOR gates, in that in the case of the redundancy decoders ($RD_v$) all address lines ($A_0$, $\bar{A}_0$ ... $A_p$, $\bar{A}_p$) form signal inputs for the NOR gates, each of these signal inputs of each NOR gate of the redundancy decoders ($RD_v$) being connected via a separable connection (F) to the respective associated address line ($A_0$, $\bar{A}_0$, ... $A_p$, $\bar{A}_p$), in that the outputs of the NOR gates of the normal decoders ($ND_\mu$) are provided for controlling in each case one first AND gate ($U_\mu^-$ or NT3), in that the outputs of the NOR gates of the redundancy decoders ($RD_v$) are provided for controlling in each case a second AND gate ($U_v^*$ or T4), in that these AND gates ($U_\mu^-$ or NT3 ; $U_v^*$ or T4) are in each case jointly controlled by one of the two activation signals (Ø3 or Ø3R) and serve in

turn for releasing a connection between a data input or data output (S/L or $\bar{S}/\bar{L}$ respectively) and the rows ($nz_\mu$ or $ez_v$ respectively) or columns belonging to the respective normal decoder ($ND_\mu$) or redundancy decoder ($RD_v$), in that furthermore the NOR gate of each individual redundancy decoder ($RD_v$), together with the second clock signal (Ø2) common to all the redundancy decoders ($RD_v$), controls a third AND gate ($U_v$ or T3), the output signal of which has an influence, as an inhibit signal (Øk), on the first activation signal (Ø3) necessary for releasing the connection between the data input or the data output (S/L, $\bar{S}/\bar{L}$) and the columns or rows ($nz_\mu$) associated in each case with the normal decoders ($ND_\mu$), in the sense of an inactivation of this first activation signal (Ø3), in particular in the form of a suppression thereof.

5. Write-read memory according to one of Claims 1 to 4, characterized in that the first, second and third AND gates ($U_\mu^-$, $U_v^*$, $U_v$) provided in the normal decoders ($ND_\mu$) and those provided in the redundancy decoders ($RD_v$) have in each case two signal inputs, one signal input in each case receiving the output of the NOR gate receiving the address lines ($A_0$, $\bar{A}_0$, ... $A_p$, $\bar{A}_p$), and the other input of the first and second AND gates ($U_\mu^-$ or $U_v^*$ respectively) in the case of the normal decoders ($ND_\mu$) receiving the first activation signal (Ø3) common to all normal decoders ($ND_\mu$), and in the case of the redundancy decoders ($RD_v$) receiving the second activation signal (Ø3R) common to all redundancy decoders ($RD_v$), in that moreover, in the case of the individual redundancy decoders ($RD_v$), the third AND gate ($U_v$) provided in each case receives at is second input the second clock signal (Ø2), in that at the output of this third AND gate ($U_v$) a signal, generated after programming of the respective redundancy decoder ($RD_v$) as a result of its then possible addressing, is available which [lacuna], with mediation of a further OR gate (OG) common to all redundancy decoders and driven on the input side by the outputs of all third AND gates ($U_v$) of the redundancy decoders ($RD_v$), as a result of which the inhibit signal (Øk) is generated at the output of this further OR gate (OG).

6. Write-read memory according to one of Claims 1 to 5, characterized in that the inhibit signal (Øk) generated at the output of the OR gate (OG) is applied, with mediation of an inverter, to an input of a fourth AND gate (U**), and in that another input of this fourth AND gate (U**) receives the second clock signal (Ø2), as a result of which the first activation signal (Ø3) which is common to all normal decoders ($ND_\mu$) and which serves to activate the first AND gate ($U_\mu^-$) provided in each case in the individual normal decoder ($ND_\mu$) is generated at the output of this fourth AND gate (U**).

7. Write-read memory according to one of the preceding claims, characterized in that in each case one normally-off MOS field-effect transistor (T) is associated with each address input ($A_0$, $\bar{A}_0$ ... $A_p$, $\bar{A}_p$) in the individual redundancy decoders

(RD$_v$), which MOS field-effect transistor forms in each case one switching transistor of the NOR gate of the respective redundancy decoder (RD$_v$), and the drain of which is applied via a separable connection (F) to the source connection of a common load transistor (T1) and hence to an output (A) of the NOR gate formed by said transistors (T), in that furthermore the output (A) of the NOR gate is applied via a transistor (T2) lying at its gate at the supply potential (V$_{DD}$) of the NOR gate to the gate of two further transistors (T3, T4), the source connection of which is connected in each case via a fuse circuit (FF1, FF2) to the reference potential (V$_{ss}$) of the NOR gate, and the drain connections of which receive, in the case of one transistor (T4), the common second activation signal (Ø3R) of the redundancy decoders (RD$_v$), and receive, in the case of the other transistor (T3), the second clock signal (Ø2) provided for joint control of the third AND gate (U$_v$) in the redundancy decoders (RD$_v$), while the source of one transistor (T4) receiving the second activation signal (Ø3R) at its drain forms the release of the connection between the data input or data output (S/L or S̄/L̄ respectively) and the output of the redundancy decoder (RD$_v$) controlling the redundant columns or rows (ez$_v$, ēz̄$_v$) belonging to the respective redundancy decoder (RD$_v$), while the other transistor (T3), representing the third AND gate (U$_v$) of the redundancy decoder (RD$_v$) and controlled by the second clock signal (02), makes available at its source connection the inhibit signal (Øk) effecting the inactivation of the first activation signal (Ø3) after selection of a corresponding redundancy decoder (RD$_v$).

8. Write-read memory according to one of Claims 1 to 7, characterized in that the fuse circuits (FF1, FF2), which are connected directly in each case at a first node to the source connection of the two transistors (T3, T4) representing in each case an AND gate, each take the form of an RS flipflop (FF1, FF2), the bases of which are in each case connected to the reference potential (V$_{ss}$) of the NOR gate forming the redundancy decoder (RD$_v$), while a second node of each of the two flipflops (FF1, FF2) are connected in each case via a MOS field-effect transistor (R) connected as a resistor to the supply potential (V$_{DD}$) of the redundancy decoder (RD$_v$).

9. Write-read memory according to one of Claims 1 to 8, characterized in that, for generating the second activation signal (Ø3R) jointly serving the provided redundancy decoders (RD$_v$), a circuit consisting of twelve normally-off MOS field-effect transistors (1 to 12) and of a capacitor (C) as well as the first and the second clock signal (Ø1, Ø2) for the operation thereof are provided, in that the first transistor (1) thereby lies with its source at the reference potential (V$_{ss}$), with its gate at the first clock signal (Ø1) and with its drain both via a second transistor (2) controlled by the second clock signal (Ø2) at the supply potential (V$_{DD}$), and is also connected to the gate of a third transistor (3), in that the third transistor (3) thereby forms, together with a fourth transistor (4), a further series connection lying between the supply potential (V$_{DD}$) and the reference potential (V$_{ss}$) and in which the fourth transistor (4) lying with its drain at the supply potential (V$_{DD}$) is controlled by the first clock signal (Ø1), in that a circuit point lying between the third and the fourth transistor (3, 4) is connected to the supply potential (V$_{DD}$) via the source-drain path of a fifth transistor (5) controlled at its gate by the second clock signal (Ø2) both to the gate of a sixth transistor (6) receiving at its drain the second clock signal (Ø2) and, via a further transistor (12) which is controlled by the first clock signal (Ø1), to the supply potential (V$_{DD}$), in that, in addition, the source connection of the sixth transistor (6) is connected on the one hand to the gate of a further transistor (7), the drain of which lies at the supply potential (V$_{DD}$) and the source of which is connected firstly to its own gate via the capacitor (C) and secondly to the drain of a further transistor (9), the source of which is connected to the reference potential (V$_{ss}$), and the gate of which is on the other hand connected to the circuit point between the third and fourth transistor (3, 4), in that, in addition, the source connection of the sixth transistor (6) is connected to the reference potential (V$_{ss}$) with the drain connection of a further transistor (10) which is controlled by the first clock signal (Ø1), in that furthermore the source connection of the sixth transistor (6) lies at the gate of a further transistor (8), the drain of which is connected to the supply potential (V$_{DD}$) and the source of which not only forms the output supplying the second activation signal (Ø3R) for the redundancy decoders (RD$_v$) but is also connected, via a further transistor (11), to the reference potential (V$_{ss}$), the gate of this transistor (11) likewise receiving the circuit point lying between the third and the fourth transistor (3, 4), and in which finally the two clock signals (Ø1, Ø2) are designed in such a manner that the trailing edge of the first clock signal (Ø1) lies temporally immediately before the appearance of the addressing signals (A$_0$, Ā$_0$, ...., A$_p$, Ā$_p$), while the second clock signal (Ø2) is identical to the common second clock signal (Ø2) for joint control of the third AND gate (U$_v$) in the individual redundancy decoders (RD$_v$).

10. Write-read memory according to at least one of the preceding claims, having a division of the columns and rows (nz$_μ$) provided for the normal operation into a left (LZF) and a right cell field half (RZF), with an organization of the associated normal decoders (ND$_μ$) in the manner of centre decoders (MD$_μ$) which are connected with the left and right cell field half (LZF, RZF) in each case to a left or right switch (LS$_μ$, RS$_μ$) respectively, the left or right switch (LS$_μ$, RS$_μ$) in each case being driven via a left or a right activation signal (Ø3$_l$ or Ø3$_r$) respectively, characterized in that the columns and rows (ez$_v$) provided as a substitute are likewise divided in each case into a left row half (ez$_{vl}$) and a right row half (ez$_{vr}$), in that each of these row halves (ez$_{vl}$, ez$_{vr}$) are selected via its own left or right redundancy

decoder (RD$_{vl}$, RD$_{vr}$), and in a that the left and right activation signal (Ø3$_l$, Ø3$_r$) is generated analogously to the first activation signal (Ø3) for normal decoders (ND$_\mu$).

11. Write-read memory according to Claim 10, characterized in that, for generating the left and right activation signal (Ø3$_l$, Ø3$_r$), in each case an inhibit signal (Øk$_l$, Øk$_r$) is used which is generated by the left or right redundancy decoders (RD$_{vl}$, RD$_{vr}$) respectively analogously to the inhibit signal (Øk) which suppresses the appearance of the first activation signal (Ø3) in normal decoders (ND$_\mu$) when appropriate.

12. Write-read memory according to Claim 10 or 11, characterized by

a) centre decoders (MD$_\mu$) which each contain a NOR gate which is realized in the form of p parallel-connected MOS transistors (NT ; p = number of address lines A$_0$ ... A$_p$ or their complement lines Ā$_0$ ... Ā$_p$), each gate of the MOS transistors being controlled by an address line (A$_0$ ... A$_p$) or its complementary address line (Ā$_0$ ... Ā$_p$), the source connections being connected to the reference potential (V$_{ss}$), and a circuit point (A) formed by the drain connections of all parallel-connected MOS transistors (NT) of the NOR gate being connected via the source-drain path of a switching transistor (NT1) controlled by the first clock signal (Ø1) to the supply potential (V$_{DD}$),

b) a switch (LS$_\mu$ or RS$_\mu$ respectively) which is connected to the left or the right on each centre decoder (MD$_\mu$) and which contains a transverse transistor (NT2$_l$ or NT2$_r$) which is connected by its gate to the supply potential (V$_{DD}$) and the current-carrying paths (source or drain) of which are connected on the one hand to the circuit point (A) of the centre decoder (MD$_\mu$), and on the other hand form the gate connection of a further switching transistor (NT3$_l$ or NT3$_r$), the left or right activation signal (Ø3$_l$, Ø3$_r$) being fed into the drain of this switching transistor (NT3$_l$, NT3$_r$) and the source connection forming a circuit node (K$_l$ or K$_r$) which is firstly connected to the left or right cell field half (LZF, RZF) in such a way that it is connected to the gates of two transistors (tr$_{\mu l}$, t̄r$_{\mu l}$ ; tr$_{\mu r}$, t̄r$_{\mu r}$) which effect the release of the connection between the data input or data output (S/L$_l$, S/L̄$_l$ ; S/L$_r$, S/L̄$_r$) and the left or right row half (nz$_{\mu l}$, nz$_{\mu r}$) provided for the normal operation, and in that this circuit node (K$_l$ or K$_r$) is secondly connected to an RS flipflop (FF3$_l$ or FF3$_r$), formed in a usual manner by two cross-couplet transistorm, in such a manner that this circuit node (K$_l$ or K$_r$) forms both the drain connection of one cross-coupled transistor and the gate connection of the other cross-couplet transistor, the source connections of these two transistors being connected to the reference potential (V$_{ss}$), and both the gate connection of one transistor and the drain connection of the other transistor being connected to the supply potential (V$_{DD}$) via a further transistor (NR$_l$, NR$_r$) connected as a resistor.

## Revendications

1. Mémoire intégrée d'enregistrement/lecture comportant des cellules disposées sous une forme matricielle suivant des colonnes et des lignes et dont l'adressage est réalisé par l'intermédiaire de décodeurs d'adresses, et dans laquelle un nombre prédéterminé des colonnes et des lignes (nz$_\mu$) est prévu pour un fonctionnement normal et le reste des colonnes et des lignes (ez$_v$) est prévu respectivement à titre de remplacement pour respectivement une colonne ou une ligne faisant partie des colonnes ou des lignes (nz$_\mu$) prévues pour le fonctionnement normal, et dans laquelle des décodeurs à redondance (RD$_v$) associés aux différentes colonnes ou lignes (ez$_v$) prévues a titre de remplacement, sont agencés et accordés sur des décodeurs normaux (ND$_\mu$) prévus pour le fonctionnement normal, de telle sorte qu'un adressage de chacune des colonnes ou des lignes (ez$_v$) prévues à titre de remplacement n'est possible qu'après une modification permanente, à savoir l'interruption d'une liaison F, dans le décodeur à redondance (RD$_v$) respectivement associé à cette colonne ou ligne, et qu'en outre cette modification est liée à une désactivation du décodeur normal (ND$_\mu$) associé respectivement aux colonnes ou lignes (nz$_\mu$) remplacées, et dans lequel les décodeurs normaux (ND$_\mu$) associés respectivement aux colonnes ou lignes (nz$_\mu$) prévues pour le fonctionnement normal, sont agencés de telle sorte qu'une sélection de l'un de ces décodeurs normaux (ND$_\mu$) est réalisée, dans le cas où un décodeur à redondance (RD$_v$) ne répond pas simultanément, par une combinaison correspondante de lignes de transmission d'adresses (A$_0$, Ā$_0$, ...., A$_p$, Ā$_p$) et au moyen d'un premier signal d'activation (Ø3R), commun à tous les décodeurs normaux (ND$_\mu$), et dans lequel les décodeurs à redondance (RD$_v$) sont agencés de telle sorte qu'une sélection de l'un de ces décodeurs à redondance (RD$_v$) est exécutée, en vue du remplacement de l'une des colonnes ou des lignes (nz$_\mu$) prévue pour le fonctionnement normal, au moyen de la combinaison, qui correspond à des décodeurs normaux (ND$_\mu$) devant être remplacés, de lignes de transmission d'adresses (A$_0$, Ā$_0$, ...., A$_p$, Ā$_p$) et au moyen d'un second signal d'activation (Ø3R) commun à tous les décodeurs à redondance (RD$_v$) et dans lequel lors de l'exécution de la modification permanente dans un ou plusieurs décodeurs à redondance (RD$_v$) et lors d'une sélection de l'un de ces décodeurs (RD$_v$), un signal d'inhibition (Øk) est produit, qui sert à empêcher la modification du niveau dudit signal d'activation (Ø3), qui est nécessaire pour la réponse des décodeurs normaux (ND$_\mu$), caractérisé par le fait que le signal d'inhibition (Øk) délivré par des décodeurs à redondance (RD$_v$) activés, est prévu en commun avec des premier et second signaux de cadence (Ø1, Ø2) pour réaliser la commande d'un circuit délivrant le premier signal d'activation (Ø3) pour les décodeurs normaux (ND$_\mu$) et formé par des transistors à effet de champ MOS (14 à 27) autobloquants ainsi que par un autre condensateur (C*), que ce circuit est agencé de telle sorte que lors de l'apparition du signal d'inhibition (Øk), l'apparition du premier signal d'activation (Ø3) est supprimé lorsqu'un décodeur normal (ND$_\mu$) est adressé en même temps que s'effectue l'adressage du décodeur à redondance (RD$_v$) déclenchant l'apparition du signal d'inhibition (Øk).

2. Mémoire d'enregistrement/lecture suivant la revendication 1, caractérisé par le fait que le circuit formé par les transistors à effet de champ MOS (14 à 27) autobloquants possédant le même type de canal, est agencé de telle sorte qu'un premier inverseur, formé par un transistor de commutation (14) commandé par le premier signal de cadence (Ø1), et par un transistor de charge (15) commandé par le second signal de cadence (Ø2), commande par sa sortie le transistor de commutation (16) d'un second inverseur, dont le transistor de charge (17) est chargé, au niveau de sa grille, par le premier signal de cadence (Ø1), que la sortie du second inverseur (16, 17) est reliée par l'intermédiaire de la voie source-drain d'un transistor de transfert (18) commandé par le second signal de cadence (Ø2), d'une part à la grille d'un autre transistor (19) - chargé au niveau de son drain par le second signal de cadence (Ø2) - et d'autre part au potentiel de référence (V$_{ss}$) par l'intermédiaire de la voie source-drain d'un transistor de décharge (20) commandé par le signal d'inhibition (Øk), que la source du transistor (19), dont la grille est chargée par la sortie du second inverseur (16, 17) par l'intermédiaire dudit transistor de transfert (18), est reliée d'une part au potentiel de référence (V$_{ss}$) par l'intermédiaire du circuit parallèle formé d'un transistor (21) commandé par le signal d'inhibition (Øk) et un transistor (22) commandé par le premier signal de cadence (Ø1) et d'autre part à un pôle d'un autre condensateur (C*) ainsi qu'aux grilles de deux transistors de charge (23, 24) - dont le drain est raccordé au potentiel d'alimentation (V$_{DD}$) -, que l'autre pôle de l'autre condensateur (C*) est raccordé aussi bien à la source d'un premier (23) des deux transistors de charge qu'au drain d'un autre transistor (25) — dont la source est raccordée au potentiel de référence (V$_{ss}$), que ce transistor (25) indiqué en dernier lieu est commandé, au niveau de sa grille, par le signal de sortie du second inverseur (16, 17), que la source de l'autre transistor de charge (24) est raccordée en série au potentiel de référence (V$_{ss}$) par l'intermédiaire du circuit parallèle formé de deux autres transistors (26, 27), dont l'un (27) est commandé par le signal d'inhibition (Øk) et dont l'autre (26) est commandé par le signal de sortie du second inverseur (16, 17), et que le premier signal d'activation (Ø3) pour le décodeur normal (ND$_\mu$) est présent au niveau d'un point du montage, qui est situé entre les bornes de drain des deux transistors (26, 27) indiquées en dernier lieu et la borne de source de l'autre transistor de charge (24).

3. Mémoire d'enregistrement/lecture selon la revendication 1 ou 2, caractérisé en ce que pour l'obtention de la suppression de la liaison entre l'entrée ou la sortie de données (S/L ou S̄/L̄) des lignes (nz$_\mu$) prévues pour le fonctionnement normal, il est prévu un circuit constitué de la manière suivante :

a) une pluralité p de transistors (NT) (p = nombre des lignes de transmission d'adresses A$_0$ à A$_p$ ou Ā$_0$ à Ā$_p$) sont branchés en parallèle à la manière d'une porte NON-OU dans un décodeur normal (ND$_\mu$), auquel cas la grille de chacun des transistors (NT) est commandée par une ligne de transmission d'adresses (A$_0$ ou Ā$_0$, ..., A$_p$ ou Ā$_p$) faisant partie de la totalité des lignes de transmission d'adresses (A$_0$, Ā$_0$, ..., A$_p$, Ā$_p$), les bornes de source de tous ces transistors (NT) sont reliées au potentiel de référence V$_{ss}$) et les bornes de drain de tous ces transistors (NT) sont raccordées à un point (A') du circuit,

b) ce point (A') du circuit est relié par l'intermédiaire de la voie source-drain d'un autre transistor (NT1) au potentiel de référence (V$_{DD}$), la commande de la grille de cet autre transistor (NT) par le premier signal de cadence (Ø1) réalisant une charge préalable de ce point du circuit au potentiel d'alimentation (V$_{DD}$),

c) le point (A') du circuit est d'autre part relié par l'intermédiaire de la voie source-drain d'un transistor transversal (NT2), dont la grille est raccordée au potentiel d'alimentation (V$_{DD}$), à la grille d'un transistor de commutation (NT3),

d) ce transistor de commutation (NT3) est commandé, au niveau de sa borne de drain, par le premier signal d'activation (Ø3), sa borne de source forme d'une part la borne de grille de deux transistors (Tr$_\mu$, T̄r$_\mu$), qui déclenchent la suppression entre l'entrée de données ou la sortie de données (S/L ou S̄/L̄) des lignes (nz$_\mu$) prévues pour le fonctionnement normal, et forme par ailleurs une borne raccordée au drain d'un premier transistor d'une bascule bistable de type RS (FF3) contenant deux transistors couplés selon un couplage croisé, et la grille de l'autre transistor de cette bascule bistable de type RS (FF3),

e) la borne de source de l'autre transistor de cette bascule bistable de type RS (FF3) est reliée aussi bien à la grille du premier transistor de la bascule bistable de type RS (FF3) que, par l'intermédiaire de la voie source-drain d'un transistor de charge (NR), au potentiel d'alimentation (V$_{DD}$), la grille de ce transistor de charge (NR) étant également raccordée au potentiel d'alimentation (V$_{DD}$),

f) les bornes de source des deux transistors, qui forment la bascule bistable de type RS (FF3), sont reliées au potentiel de référence (V$_{ss}$).

4. Mémoire d'enregistrement/lecture suivant l'une des revendications 1 à 3, caractérisée par le fait qu'aussi bien chacun des décodeurs normaux (ND$_\mu$) que chacun des décodeurs à redondance (rD$_v$) contient au moins une porte NON-OU, que dans le cas des décodeurs normaux (ND$_\mu$), la combinaison correspondante respective de lignes de transmission d'adresses (A$_0$, Ā$_0$, ..., A$_p$, Ā$_p$) forme des entrées de signaux pour la porte NON-OU, que dans le cas des décodeurs à redondance (RD$_v$), toutes les lignes de transmission d'adresses (A$_0$, Ā$_0$, ..., A$_p$, Ā$_p$) forment des signaux d'entrée pour les portes NON-OU, chacun de ces signaux d'entrée de chaque porte NON-OU des décodeurs à redondance (RD$_v$) étant reliée par l'intermédiaire d'une liaison (F) pouvant être supprimée à la ligne respectivement associée de transmission d'adresses (A$_0$, Ā$_0$, ..., A$_p$, Ā$_p$), que les sorties des portes NON-OU des décodeurs normaux (ND$_\mu$) sont prévues pour commander respectivement une première porte ET (U$_\mu^-$ ou NT3), que les sorties des portes NON-OU des décodeurs à redondance (RD$_v$) sont prévues pour la commande d'une seconde porte respective ET (U$_v$* ou T4), que cette porte ET (U$_\mu^-$ ou NT3 ; U$_v$* ou T4) sont commandées respectivement par l'un des deux signaux d'activation (Ø3 ou Ø3R) et, pour leur part, servent à autoriser une liaison entre une entrée ou une sortie de données (S/L ou S̄/L̄) et les lignes (nz$_\mu$ ou ez$_v$) ou les colonnes, associées au décodeur normal (ND$_\mu$) ou au décodeur à redondance (RD$_v$) considéré, qu'en outre la porte NON-ET de chaque décodeur à redondance (RD$_v$) commande, conjointement avec le second signal de cadence (Ø2) commun à tous les décodeurs à redondance (RD$_v$), une troisième porte ET (U$_v$ ou T3), dont le signal de sortie influe, en tant que signal d'inhibition (Øk), sur le premier signal d'activation (Ø3), qui est nécessaire pour la suppression de la liaison entre l'entrée de données ou la sortie de données (S/L, S̄/L̄) et les colonnes ou lignes (nz$_\mu$) associées respectivement aux décodeurs normaux (ND$_\mu$), dans le sens d'une inactivation de ce premier signal d'activation (Ø3), notamment sous la forme d'une suppression.

5. Mémoire d'enregistrement/lecture suivant l'une des revendications 1 à 4, caractérisée par le fait que les première, seconde et troisième portes ET (U$_\mu^-$, U$_v$*, U$_v$), prévues dans des décodeurs normaux (ND$_\mu$) et dans les décodeurs à redondance (RD$_v$) possèdent chacune deux entrées de signaux, une entrée des signaux étant chargée respectivement par le signal de sortie de la porte NON-OU chargée par la ligne de transmission d'adresses (A$_0$, Ā$_0$, ..., A$_p$, Ā$_p$) et l'autre entrée de la première ou de la seconde porte ET (U$_\mu^-$ ou U$_v$*) étant chargée, dans le cas des détecteurs normaux (ND$_\mu$), par le premier signal d'activation (Ø3) commun à tous les décodeurs normaux (ND$_\mu$), et, dans le cas des décodeurs a redondance (RD$_v$), par le second signal d'activation (Ø3R) commun à tous les décodeurs à redondance (RD$_v$), qu'en outre la troisième porte ET (U$_v$), prévue respectivement dans le cas des différents décodeurs à redondance (RD$_v$), est chargée au niveau de sa seconde entrée par le second signal de cadence (Ø2), qu'à la sortie de cette troisième porte ET (U$_v$) est disponible un signal — qui apparaît après la programmation du décodeur à redondance (RD$_v$) considéré sur la base de son adressage alors possible — qui est envoyé à une autre porte OU (OG), qui est commune à tous les décodeurs à redondance et dont l'entrée est commandée par les signaux de sortie de l'ensemble des troisièmes portes ET (U$_v$) des décodeurs à redondance (RD$_v$), ce qui fait apparaître le signal d'inhibition (Øk) sur la sortie de cette autre porte OU (OG).

6. Mémoire d'enregistrement/lecture suivant l'une des revendications 1 à 5, caractérisée par le fait que le signal d'inhibition (Øk) apparaissant à la sortie de la porte OU (OG) est appliqué, par l'intermédiaire d'un inverseur, à une entrée d'une quatrième porte ET (U**) et qu'une autre entrée de cette quatrième porte ET (U**) est chargée par le second signal de cadence (Ø2), ce qui fait apparaître, sur la sortie de cette quatrième porte ET (U**), le premier signal d'activation (Ø3) utilisé pour activer la première porte ET (U$_\mu^-$), prévue respectivement dans les différents décodeurs normaux (ND$_\mu$), et commun à tous les décodeurs normaux (ND$_\mu$).

7. Mémoire d'enregistrement/lecture suivant l'une des revendications précédentes, caractérisée par le fait que dans les différents décodeurs à redondance (RD$_v$) à chaque entrée d'adresses (A$_0$, Ā$_0$, ..., A$_p$, Ā$_p$) est associé respectivement un transistor à effet de champ MOS (T) autobloquant, qui forme respectivement un transistor de commutation de la porte NON-OU du décodeur à redondance (RD$_v$) considéré et dont le drain est raccordé par l'intermédiaire d'une liaison (F) pouvant être interrompue, à la borne de source d'un transistor de charge commun (T1) et par conséquent à une sortie (A) de la porte NON-OU formée par lesdits transistors (T), qu'en outre la sortie (A) de la porte NON-ET est raccordée par l'intermédiaire d'un transistor (T2) dont la grille est raccordée au potentiel d'alimentation (V$_{DD}$) de la porte NON-OU, à la grille de deux autres transistors (T3, T4), dont la borne de source est raccordée respectivement par l'intermédiaire d'un circuit de sécurité (FF1, FF2) au potentiel de référence (V$_{SS}$) de la porte NON-OU et dont les bornes de drain sont chargées, dans le cas d'un transistor (T4), par le second signal commun d'activation (Ø3R) des décodeurs à redondance (RD$_v$) et, dans le cas de l'autre transistor (T3), par le second signal de cadence (Ø2) prévu pour réaliser la commande conjointe de la troisième porte ET (U$_v$) dans les décodeurs à redondance (RD$_v$), tandis que la source du transistor (T4), dont le drain est chargé par le second signal d'activation (Ø3R), forme la sortie du décodeur à redondance (RD$_v$), qui commande l'interruption de la liaison entre l'entrée de données ou la sortie de données (S/L ou S̄/L̄) et les colonnes ou lignes redondantes (ez$_v$, ēz̄$_v$) faisant partie du décodeur à redondance (RD$_v$) considéré, tandis que l'autre transistor (T3), qui représente la troisième porte ET (U$_v$) du décodeur à redondance (RD$_v$) et commandé par le second signal de cadence (Ø2), délivre, sur sa borne de source, le signal d'inhibition (Øk) provoquant l'inactivation du premier signal d'activation (Ø3) après la sélection d'un décodeur à redondance (RD$_v$) correspondant.

8. Mémoire d'enregistrement/lecture suivant l'une des revendications 1 à 7, caractérisée par le fait que les circuits de sécurité (FF1, FF2), qui sont reliés directement, respectivement au niveau d'un premier nœud, à la borne de source des deux transistors (T3, T4) représentant des portes ET respectives, sont formés chacun par une bascule bistable de type RS (FF1, FF2), dont les points de base sont reliés respectivement au potentiel de référence ($V_{ss}$) de la porte NON-OU formant le décodeur à redondance ($RD_v$), tandis que des seconds nœuds respectifs des deux bascules bistables (FF1, FF2) sont reliés respectivement par l'intermédiaire d'un transistor à effet de champ MOS (R) branché en tant que résistance, au potentiel d'alimentation ($V_{DD}$) du décodeur à redondance ($RD_v$).

9. Mémoire d'enregistrement/lecture suivant l'une des revendications 1 à 8, caractérisée par le fait que pour l'obtention du second signal d'activation (Ø3R) utilisé en commun pour les décodeurs à redondance ($RD_v$) prévus, il est prévu un circuit, constitué par douze transistors à effet de champ MOS autobloquants (1 à 12) et par un condensateur (C), ainsi que, pour le fonctionnement de ce circuit, des premier et second signaux de cadence (Ø1, Ø2), que le premier transistor (1) est relié par sa source au potentiel de référence ($V_{ss}$), par sa grille au premier signal de cadence (Ø1) et par son drain aussi bien au potentiel d'alimentation ($V_{DD}$), par l'intermédiaire d'un second transistor (2) commandé par le second signal de cadence (Ø2), qu'à la grille d'un troisième transistor (3), que le troisième transistor (3) forme, conjointement avec un quatrième transistor (4), un autre circuit série disposé entre le potentiel d'alimentation ($V_{DD}$) et le potentiel de référence ($V_{ss}$) et dans lequel le quatrième transistor (4) raccordé par son drain au potentiel d'alimentation ($V_{DD}$) est commandé par le premier signal de cadence (Ø1), qu'un point de circuit situé entre les troisième et quatrième transistors (3, 4) est relié, par l'intermédiaire de la voie source-drain d'un cinquième transistor (5), dont la grille est commandée par le second signal de cadence (Ø2), aussi bien à la grille d'un sixième transistor (6), dont le drain est chargé par le second signal de cadence (Ø2), que par l'intermédiaire d'un autre transistor (12), qui est commandé par le premier signal de cadence (Ø1), au potentiel d'alimentation ($V_{DD}$), qu'en outre la borne de source du sixième transistor (6) est reliée d'une part à la grille d'un autre transistor (7), dont le drain est placé au potentiel d'alimentation ($V_{DD}$) et dont la source est raccordée d'une part à la grille par l'intermédiaire du condensateur (C), et d'autre part au drain d'un autre transistor (9), dont la source est reliée au potentiel de référence ($V_{SS}$), et dont la grille est reliée à nouveau au point du circuit situé entre les troisième et quatrième transistors (3, 4), qu'en outre la borne de source du sixième transistor (6) est reliée au potentiel de référence ($V_{ss}$) par la borne de drain d'un autre transistor (10), qui est commandé par le premier signal de cadence (Ø1), qu'en outre la borne de source du sixième transistor (6) est raccordée à la grille d'un autre transistor (8), dont le drain est raccordé au potentiel d'alimentation ($V_{DD}$) et dont la source d'une part forme la sortie délivrant le second signal d'activation (Ø3R) pour les décodeurs à redondance ($RD_v$) et est également reliée au potentiel de référence ($V_{ss}$) par l'intermédiaire d'un autre transistor (11), dont la grille est également chargée par le point de circuit situé entre les troisième et quatrième transistors (3, 4), et que, enfin, les signaux de cadence (Ø1, Ø2) sont agencés de telle sorte que les flancs retombants du premier signal de cadence (Ø1) apparaissent dans le temps juste avant l'apparition des signaux d'adressage ($A_0$, $\bar{A}_0$, ..., $A_p$, $\bar{A}_p$), tandis que le second signal de cadence (Ø2) est identique au second signal de cadence (Ø2) qui est commun pour la commande conjointe des troisièmes portes ET ($U_v$) dans les différents décodeurs à redondance ($RD_v$).

10. Mémoire d'enregistrement/lecture suivant au moins l'une des revendications précédentes, dans laquelle il est prévu une subdivision des colonnes ou des lignes ($nz_\mu$), prévues pour le fonctionnement normal, en un demi-champ de cellules de gauche (LZF) et en un demi-champ de cellules de droite (RZF), et dans lequel les décodeurs normaux ($ND_\mu$) associés sont réalisés à la manière de décodeurs médians ($MD_\mu$), qui sont reliés par la moitié de champ de cellules de gauche ou de droite (LZF, RZF), respectivement à un interrupteur de gauche ou de droite ($LS_\mu$, $RS_\mu$), les interrupteurs de gauche ou de droite ($LS_\mu$, $RS_\mu$) étant commandés respectivement par l'intermédiaire d'un signal d'activation de gauche ou de droite (Ø3$_l$ ou Ø3$_r$), caractérisée par le fait que les colonnes ou lignes ($ez_v$) prévues à titre de remplacement sont également réparties en une moitié de lignes de gauche ($ez_{vl}$) et une moitié de lignes de droite ($ez_{vr}$), que chacune de ces moitiés de lignes ($ez_{vl}$, $ez_{vr}$) est sélectionnée par l'intermédiaire d'un décodeur à redondance de gauche ou de droite ($RD_{vl}$, $RD_{vr}$) particulier, et que le signal d'activation de gauche ou de droite (Ø3$_l$, Ø3$_r$) est produit d'une manière analogue au premier signal d'activation (Ø3) pour les décodeurs normaux ($ND_\mu$).

11. Mémoire d'enregistrement/lecture suivant la revendication 10, caractérisée par le fait que pour l'obtention du signal d'activation de gauche ou de droite (Ø3$_l$, Ø3$_r$), on utilise des signaux d'inhibition respectifs (Øk$_l$, Øk$_r$), qui sont produits, par les décodeurs à redondance de gauche et de droite ($RD_{vl}$, $RD_{vr}$) de la même manière que le signal d'inhibition (Ø$_k$), qui supprime éventuellement l'apparition du premier signal d'activation (Ø3) dans le cas de décodeurs normaux ($ND_\mu$).

12. Mémoire d'enregistrement/lecture suivant la revendication 10 ou 11, caractérisée par :

a) des décodeurs médians ($MD_\mu$), qui contiennent chacun une porte NON-OU réalisée sous la forme de p transistors MOS (NT ; p = nombre des lignes de transmission d'adresses $A_0$ ... $A_p$ ou des lignes complémentaires des précédentes ($\bar{A}_0$ ... $\bar{a}_p$) branchées en parallèle, auquel cas chaque grille des transistors MOS est commandée par une ligne de transmission d'adresses ($A_0$ ... $A_p$) ou la ligne d'adresses ($\bar{A}_0$ ... $\bar{A}_p$) qui en est la complémentaire, les bornes de source sont reliées au potentiel de référence (V$_{ss}$) et un point de circuit (A), formé à partir des bornes de drain de tous les transistors MOS (NT) de la porte NON-OU, branchés en parallèle, est raccordé au potentiel d'alimentation (V$_{DD}$), par l'intermédiaire de la voie source-drain d'un transistor de commutation (NT1) commandé par le premier signal de cadence (Ø1).

b) un interrupteur (LS$_\mu$ ou RS$_\mu$), qui se raccorde à gauche ou à droite à chaque décodeur médian (MD$_\mu$) et comporte un transistor transversal (NT2$_l$ ou NT2$_r$), dont la grille est reliée au potentiel d'alimentation (V$_{DD}$) et dont les voies (source et drain) véhiculant le courant d'une part sont raccordées au point de circuit (A) du décodeur médian (MD$_\mu$) et d'autre part forment le raccord de grille d'un autre transistor de commutation (NT3$_l$ ou NT3$_r$), auquel cas le signal d'activation de gauche ou de droite (03$_l$, 03$_r$) est injecté dans le drain de ce transistor de commutation (NT3$_l$, NT3$_r$), et la borne de source forme un noeud de circuit (K$_l$ ou K$_r$), qui est raccordé d'une part à la moitié du champ de cellules de gauche ou de droite (LZF, RZF) de telle sorte qu'il est relié aux grilles de deux transistors (tr$_{\mu l}$, t̄r̄$_{\mu l}$ ; tr$_{\mu r}$, t̄r̄$_{\mu r}$) qui déclenchent la suppression de la liaison entre l'entrée de données ou la sortie de données (S/L$_l$, S̄/L̄$_l$ ; S/L$_r$, S̄/L̄$_r$) et la moitié de ligne de gauche ou de droite (nz$_{\mu l}$, nz$_{\mu r}$) prévue pour le fonctionnement normal, et que ce noeud de circuit (K$_l$ ou K$_r$) est relié d'autre part à une bascule bistable de type RS (FF3$_l$ ou FF3$_r$), formée de façon usuelle par deux transistors couplés selon un couplage croisé, de telle sorte que ce noeud de circuit (K$_l$ ou K$_r$) forme aussi bien la borne de drain d'un transistor couplé selon un couplage croisé que la borne de grille de l'autre transistor couplé selon un couplage croisé, auquel cas les bornes de sources de ces deux transistors sont reliées au potentiel de référence (V$_{ss}$) et aussi bien la borne de grille d'un transistor que la borne de drain de l'autre transistor sont reliées au potentiel d'alimentation (V$_{DD}$) par l'intermédiaire d'un autre transistor (NR$_l$, NR$_r$) branché en tant que résistance.

FIG 1

FIG 2

# FIG 2a

FIG 3

EP 0 170 727 B1

# FIG 3a

# FIG 3c

# FIG 3b

## FIG 4a

| | | | | |
|---|---|---|---|---|
| nz$_{\mu l}$ | LS$_\mu$ | MD$_\mu$ | RS$_\mu$ | nz$_{\mu r}$ |
| LZF | | | | RZF |

ø3$_l$    ø3$_r$

## FIG 4b

| | | | | |
|---|---|---|---|---|
| nz$_{\mu l}$ | LS$_\mu$ | MD$_\mu$ | RS$_\mu$ | nz$_{\mu r}$ |
| LZF | | | | RZF |

ø3$_l$    ø3$_r$

økl    ø2    økr

| ez$_{vl}$ | RD$_{vl}$ |
|---|---|

| RD$_{vr}$ | ez$_{vr}$ |
|---|---|

ø3R    ø3R

# FIG 5

EP 0 170 727 B1